# EUROPEAN PATENT APPLICATION

(11) **EP 4 773 744 A1**
(43) Date of publication of application: **08.07.2026**
(21) Application number: 24860277.3
(22) Date of filing: 16.08.2024
(51) Int. Cl.: H05K 7/20, F28D 15/02

(54) **CONDENSING PANEL ASSEMBLY AND HEAT DISSIPATION DEVICE INCLUDING SAME**

(30) Priority: 28.08.2023 KR 20230112780; 04.10.2023 KR 20230131648; 04.10.2023 KR 20230131649; 04.10.2023 KR 20230131650; 13.08.2024 KR 20240107994
(71) Applicant: KMW Inc., Hwaseong-si, Gyeonggi-do 18462 (KR)
(72) Inventor: KIM, Duk Yong, Yongin-si Gyeonggi-do 17086 (KR); JI, Kyo Sung, Hwaseong-si Gyeonggi-do 18484 (KR); PARK, Min Sik, Hwaseong-si Gyeonggi-do 18376 (KR); RYU, Chi Back, Hwaseong-si Gyeonggi-do 18378 (KR); SEO, Jin Kook, Busan 46726 (KR); CHOI, In Hwa, Yongin-si Gyeonggi-do 17148 (KR)
(74) Representative: impuls legal PartG mbB
(86) International application number: PCT/KR2024/012209
(87) International publication number: WO 2025/048356

(57) **Abstract**

The present invention relates to a condensing panel assembly and a heat dissipation device including same, and, particularly, comprises: an evaporation panel assembly which has a storage unit for storing a refrigerant capable of phase-changing according to temperature, and of which at least a part of the lower surface is **in** surface thermal contact with heating surfaces of heating elements; and a plurality of condensing panel assemblies which are coupled to the evaporation panel assembly so as to allow communication with the storage unit, and which emit heat transferred from the heating elements through heat exchange with the outside air (outdoor air), wherein each of the plurality of condensing panel assemblies include: a one-side heat conduction panel sheet-metal processed through press-molding as a metal panel member having at least a predetermined thermal conductivity; and an other-side heat conduction panel sheet-metal processed through press-molding as the same metal panel member as the one-side heat conduction panel, and thus the heat dissipation performance of the heat dissipation device is maximized.

## Description

### [Technical Field]

The present disclosure relates to a condensing panel assembly and a heat dissipation device including the same, and more particularly, to a condensing panel assembly and a heat dissipation device including the same, which can prevent physical shaking caused by an increase in internal pressure generated during gas-liquid circulation of a refrigerant, and achieve a shorter gas-liquid circulation cycle.

### [Background Art]

In various industrial fields such as communications, electronics, and electricity, related technologies are continuously being developed to a high level for application to more advanced industries. In order to develop highly advanced technologies, high-output energy is required, and devices that use high-output energy inevitably face the problem of high heat generation. Thus, the development of a heat dissipation system at an appropriate level should be accompanied therewith.

The heat dissipation system is used in various industries, including air conditioners, mobile communications, data centers, air mobility, electric vehicles, energy storage devices, and displays. Such a heat dissipation system is one of the major causes of power consumption, and the power consumption is gradually increasing as industries continue to develop.

In general, a heat dissipation device may be broadly classified into an active cooling device and a passive cooling device. The active cooling device mainly utilizes forced convection generated by a fan, whereas the passive cooling device may be classified as a technology that utilizes natural convection without using a fan.

However, a conventional heat dissipation system has limitations in dissipating a high level of heat generated by continuously developing and advanced technologies. Thus, there is a need in related industrial fields for innovative technologies capable of solving these problems, and as part of efforts to solve them, heat dissipation mechanisms are being developed.

A phase change refers to a change in the inherent state of liquid, gas, or solid when it accumulates a large amount of energy or releases stored thermal energy.

The phase change refers to a change in the physical arrangement of molecules rather than a chemical reaction such as chemical bonding or formation. The heat in a state in which no phase change occurs when energy is applied to a substance is referred to as sensible heat, whereas the heat used during a phase change is referred to as latent heat.

However, the heat dissipation mechanism has a problem in that pressure increases as temperature rises, because temperature and pressure are proportional to each other. When pressure increases due to high temperature conducted from a heating element within the sealed heat dissipation mechanism, it may cause the heat dissipation mechanism itself to rupture. To address this problem, it is necessary to prevent the pressure from increasing, and the heat dissipation mechanism requires a sufficient internal volume to allow pressure equilibrium to be achieved during the phase-change circulation process of a substance.

In addition, the heat transferred to the heat dissipation mechanism should be used as much as possible for the phase change of the refrigerant. However, if energy is used for the shaking (movement) of the heat dissipation mechanism itself due to an increase in internal pressure, a gas-liquid circulation cycle may be prolonged, thereby resulting in deterioration of heat dissipation performance.

### [Disclosure]

### [Technical Problem]

The present disclosure is proposed to resolve the aforementioned technical issues and is directed to providing a condensing panel assembly and a heat dissipation device including the same, which are capable of maximizing heat dissipation performance.

In addition, the present disclosure is also directed to providing a condensing panel assembly and a heat dissipation device including the same, which are capable of shortening a gas-liquid circulation cycle by minimizing the conversion of thermal energy required for the phase change of a liquid refrigerant into a gas refrigerant into physical force, and inducing more active gas-liquid circulation.

Further, the present disclosure is also directed to providing a condensing panel assembly and a heat dissipation device including the same, which are capable of improving heat dissipation performance by rapidly inducing the collection and transfer of a liquid refrigerant, condensed from a gas refrigerant, to a region close to a heating element.

Technical issues of the present disclosure are not limited to the technical issues mentioned above, and other technical issues not mentioned above will be clearly understood by those skilled in the art from the following description.

### [Technical Solution]

A condensing panel assembly according to an embodiment of the present disclosure includes a one-side heat conduction panel that is a metal panel member having at least a predetermined thermal conductivity and is formed by sheet-metal processing through a press forming process and an other-side heat conduction panel that is a metal panel member identical to the one-side heat conduction panel and is formed by sheet-metal processing through a press forming process, and peripheral edges of the one-side heat conduction panel and the other-side heat conduction panel, except for lower ends thereof in a gravity direction, are joined to each other to form a refrigerant flow space through which a refrigerant flows, and the lower ends of the one-side heat conduction panel and the other-side heat conduction panel are coupled to communicate with an evaporation panel assembly in which a reservoir is formed to store condensed liquid refrigerant from the refrigerant flow space after falling.

The one-side heat conduction panel and the other-side heat conduction panel may be formed with a plurality of strength reinforcing portions recessed inward to contact each other within the refrigerant flow space.

Portions of the plurality of strength reinforcing portions that contact each other within the refrigerant flow space may be joined by a welding method.

The refrigerant flow space may include a first refrigerant flow path formed to have a maximum spacing in a thickness direction of the refrigerant flow space, corresponding to a maximum separation distance between the one-side heat conduction panel and the other-side heat conduction panel, and formed to surround a periphery of each of the plurality of strength reinforcing portions, and a second refrigerant flow path formed by being recessed from the one-side heat conduction panel and the other-side heat conduction panel toward the refrigerant flow space, and formed between each of the plurality of strength reinforcing portions and the first refrigerant flow path.

A recessed depth of the second refrigerant flow path toward the refrigerant flow space may be formed such that the second refrigerant flow path is spaced apart from the refrigerant flow space in the thickness direction within the refrigerant flow space.

A recessed depth of the second refrigerant flow path may be greater than at least a recessed depth of the first refrigerant flow path and smaller than the plurality of strength reinforcing portions.

The second refrigerant flow path may be defined to be distinguished from an adjacent second refrigerant flow path by the first refrigerant flow path.

The lower ends of the one-side heat conduction panel and the other-side heat conduction panel may be coupled to overlap with the reservoir of the evaporation panel assembly.

The lower ends of the one-side heat conduction panel and the other-side heat conduction panel may pass through installation slits formed in a mounting panel coupled to an upper surface of the evaporation panel assembly so as to mediate coupling with the evaporation panel assembly, and may be coupled so as to be seated in the reservoir.

The one-side heat conduction panel and the other-side heat conduction panel may be welded along peripheries of the installation slits after being coupled to the installation slits of the mounting panel.

A plurality of rigid reinforcing members coupled to support a lower surface of the mounting panel and a bottom surface of the reservoir may be arranged in the reservoir of the evaporation panel assembly in a plurality of spaced rows, and upper surfaces of the one-side heat conduction panel and the other-side heat conduction panel, which are defined by division grooves formed in a groove shape on upper portions of the plurality of rigid reinforcing members, may be supported by the lower surface of the mounting panel.

The peripheral edges of the one-side heat conduction panel and the other-side heat conduction panel, except for the lower ends coupled to the evaporation panel assembly, may be joined to each other to form the refrigerant flow space.

The condensing panel assembly may further include a plurality of condensed refrigerant collection absorbers disposed in the refrigerant flow space formed between the one-side heat conduction panel and the other-side heat conduction panel to guide condensed refrigerant.

A condensing panel assembly according to another embodiment of the present disclosure may include a one-side heat conduction panel that is a metal panel member having at least a predetermined thermal conductivity and is formed by sheet-metal processing through a press forming process, an other-side heat conduction panel that is a metal panel member identical to the one-side heat conduction panel and is formed by sheet-metal processing through a press forming process, and a plurality of condensed refrigerant collection absorbers (hereinafter abbreviated as "absorbers") disposed in a refrigerant flow space formed between the one-side heat conduction panel and the other-side heat conduction panel, the absorbers being elongated in a gravity direction and arranged to be supported while simultaneously contacting an inner surface of the one-side heat conduction panel forming one heat dissipation surface of the refrigerant flow space and an inner surface of the other-side heat conduction panel forming another heat dissipation surface of the refrigerant flow space.

The absorber may be provided in any one form of a metal foam formed by braiding metal wires or a metal sintered body obtained by sintering metal powder.

The absorber may be formed with a plurality of pores having sizes that allow liquid refrigerant condensed in the refrigerant flow space to be absorbed by capillary force or surface tension.

The one-side heat conduction panel and the other-side heat conduction panel may be formed with a plurality of absorber installation grooves corresponding to the number of the absorbers, the absorber installation grooves supporting the absorbers to prevent movement thereof within the refrigerant flow space.

The plurality of absorbers and the plurality of absorber installation grooves each may be arranged to be spaced apart in a horizontal direction.

When lower ends of the one-side heat conduction panel and the other-side heat conduction panel are coupled to an evaporation panel assembly in which a reservoir is formed to store liquid refrigerant that has fallen after being condensed from the refrigerant flow space, the absorber may have a length that protrudes further downward than the lower ends of the one-side heat conduction panel and the other-side heat conduction panel such that a lower end thereof is positioned in the reservoir of the evaporation panel assembly.

Peripheral edges of the one-side heat conduction panel and the other-side heat conduction panel, except for the lower ends coupled to the evaporation panel assembly, may be joined to each other to form the refrigerant flow space.

The one-side heat conduction panel and the other-side heat conduction panel may be formed with a plurality of strength reinforcing portions recessed inward so as to contact each other within the refrigerant flow space.

Portions of the plurality of strength reinforcing portions that contact each other within the refrigerant flow space may be joined by a welding method.

The one-side heat conduction panel and the other-side heat conduction panel may be formed with a plurality of absorber installation grooves corresponding to the number of the absorbers, the absorber installation grooves supporting the absorbers so as to prevent movement thereof within the refrigerant flow space, and the plurality of strength reinforcing portions may be formed in regions of the one-side heat conduction panel and the other-side heat conduction panel that are not occupied by the plurality of absorber installation grooves.

The lower ends of the one-side heat conduction panel and the other-side heat conduction panel may pass through installation slits formed in a mounting panel coupled to an upper surface of the evaporation panel assembly so as to mediate coupling with the evaporation panel assembly, and may be coupled so as to be seated in the reservoir.

The one-side heat conduction panel and the other-side heat conduction panel may be welded along peripheries of the installation slits after being coupled to the installation slits of the mounting panel.

A plurality of rigid reinforcing members coupled to support a lower surface of the mounting panel and a bottom surface of the reservoir may be arranged in the reservoir of the evaporation panel assembly in a plurality of rows, and the one-side heat conduction panel and the other-side heat conduction panel may be supported, at one lower-side surface and the other lower-side surface thereof, between the plurality of rigid reinforcing members.

A heat dissipation device according to an embodiment of the present disclosure includes an evaporation panel assembly that is in surface thermal contact with a heat-generating surface of a heating element and in which a reservoir storing a liquid refrigerant of a refrigerant is formed, a plurality of condensing panel assemblies that are coupled to the evaporation panel assembly and in which a gas refrigerant phase-changed in the reservoir diffuses and condenses, and a mounting panel configured to mediate slit coupling between the evaporation panel assembly and the condensing panel assemblies, and the evaporation panel assembly is made of copper, and the condensing panel assemblies are made of SUS.

The plurality of condensing panel assemblies may form a refrigerant flow space through which the liquid refrigerant and the gas refrigerant flow, by joining peripheral edges of two base panels made of SUS and a plurality of strength reinforcing portions formed therein.

The plurality of condensing panel assemblies may be formed with a plurality of refrigerant flow paths through which the liquid refrigerant flows in a gravity direction, and each of the plurality of refrigerant flow paths may be provided with an absorber formed of a braided wire mesh.

A plurality of strength reinforcing members for reinforcing strength between the evaporation panel assembly and the mounting panel may be coupled to the evaporation panel assembly by a brazing method.

A heat dissipation device according to another embodiment of the present disclosure includes an evaporation panel assembly in which a reservoir storing a refrigerant capable of phase change according to temperature is formed and at least a portion of a lower surface thereof is in surface thermal contact with heat-generating surfaces of heating elements, and a plurality of condensing panel assemblies coupled to the evaporation panel assembly to communicate with the reservoir and configured to release heat transferred from the heating elements through heat exchange with outside air (outdoor air), and each of the plurality of condensing panel assemblies includes a one-side heat conduction panel that is a metal panel member having at least a predetermined thermal conductivity and is formed by sheet-metal processing through a press forming process, and an other-side heat conduction panel that is a metal panel member identical to the one-side heat conduction panel and is formed by sheet-metal processing through a press forming process, and peripheral edges of the one-side heat conduction panel and the other-side heat conduction panel, except for lower ends thereof in a gravity direction, are joined to each other to form a refrigerant flow space through which a refrigerant flows, and the lower ends of the one-side heat conduction panel and the other-side heat conduction panel are coupled to communicate with the reservoir of the evaporation panel assembly.

The peripheral edges of the one-side heat conduction panel and the other-side heat conduction panel, except for the lower ends coupled to the evaporation panel assembly, may be joined to each other to form the refrigerant flow space.

The one-side heat conduction panel and the other-side heat conduction panel may be formed with a plurality of strength reinforcing portions recessed inward so as to contact each other within the refrigerant flow space.

Portions of the plurality of strength reinforcing portions that contact each other within the refrigerant flow space may be joined by a welding method.

The refrigerant flow space may include a first refrigerant flow path formed to have a maximum spacing in a thickness direction of the refrigerant flow space, corresponding to a maximum separation distance between the one-side heat conduction panel and the other-side heat conduction panel, and formed to surround a periphery of each of the plurality of strength reinforcing portions, and a second refrigerant flow path formed by being recessed from the one-side heat conduction panel and the other-side heat conduction panel toward the refrigerant flow space, and formed between each of the plurality of strength reinforcing portions and the first refrigerant flow path.

A recessed depth of the second refrigerant flow path toward the refrigerant flow space may be formed so that the second refrigerant flow path is spaced apart from the refrigerant flow space in a thickness direction within the refrigerant flow space.

A recessed depth of the second refrigerant flow path may be greater than at least a recessed depth of the first refrigerant flow path and smaller than the plurality of strength reinforcing portions.

The second refrigerant flow path may be defined so as to be distinguished from an adjacent second refrigerant flow path by the first refrigerant flow path.

Lower ends of the one-side heat conduction panel and the other-side heat conduction panel may be coupled to overlap with the reservoir of the evaporation panel assembly.

The heat dissipation device may further include a mounting panel coupled to an upper surface of the evaporation panel assembly so as to mediate coupling between the evaporation panel assembly and the plurality of condensing panel assemblies, and the lower ends of the one-side heat conduction panel and the other-side heat conduction panel may pass through installation slits formed in the mounting panel and may be coupled so as to be seated in the reservoir.

The one-side heat conduction panel and the other-side heat conduction panel may be welded along peripheries of the installation slits after being coupled to the installation slits of the mounting panel.

A plurality of rigid reinforcing members coupled to support a lower surface of the mounting panel and a bottom surface of the reservoir may be arranged in the reservoir of the evaporation panel assembly in a plurality of spaced rows, and upper surfaces of the one-side heat conduction panel and the other-side heat conduction panel, which are defined by division grooves formed in a groove shape on upper portions of the plurality of rigid reinforcing members, may be supported by the lower surface of the mounting panel.

The condensing panel assembly may further include a plurality of condensed refrigerant collection absorbers (hereinafter abbreviated as "absorbers") disposed in a refrigerant flow space formed between the one-side heat conduction panel and the other-side heat conduction panel, the absorbers being elongated in a gravity direction and arranged so as to be supported while simultaneously contacting an inner surface of the one-side heat conduction panel forming one heat dissipation surface of the refrigerant flow space and an inner surface of the other-side heat conduction panel forming another heat dissipation surface of the refrigerant flow space.

The absorber may be provided in any one form of a metal foam formed by braiding metal wires or a metal sintered body obtained by sintering metal powder.

The absorber may be formed with a plurality of pores having sizes that allow liquid refrigerant condensed in the refrigerant flow space to be absorbed by capillary force or surface tension.

The one-side heat conduction panel and the other-side heat conduction panel may be formed with a plurality of absorber installation grooves corresponding to the number of the absorbers, the absorber installation grooves supporting the absorbers so as to prevent movement thereof within the refrigerant flow space.

The plurality of absorbers and the plurality of absorber installation grooves each may be arranged to be spaced apart in a horizontal direction.

When the lower ends of the one-side heat conduction panel and the other-side heat conduction panel are coupled to the evaporation panel assembly in which the reservoir is formed to store liquid refrigerant that has fallen after being condensed from the refrigerant flow space, the absorber may have a length that protrudes further downward than the lower ends of the one-side heat conduction panel and the other-side heat conduction panel such that a lower end thereof is positioned in the reservoir of the evaporation panel assembly.

The heat dissipation device may further include a heat transfer plate assembly configured to receive heat generated from the heating elements and to mediate transfer thereof to a lower surface of the evaporation panel assembly.

The heat transfer plate assembly may include a coupling frame provided in a quadrangular frame shape having an empty center, and a heat transfer panel coupled to a central portion of the coupling frame, a lower surface of the heat transfer panel being in surface thermal contact with heat-generating surfaces of the heating elements and an upper surface thereof being in surface thermal contact with a lower surface of the evaporation panel assembly.

At least one pair of panel fixing hooks for fixing the heat transfer panel may be integrally formed at an inner end of the coupling frame.

The heat dissipation device may further include a mounting panel coupled to an upper surface of the evaporation panel assembly so as to mediate coupling between the evaporation panel assembly and the plurality of condensing panel assemblies, and the coupling frame may be formed with support hook portions that are inserted through extension holes formed in the evaporation panel assembly and the mounting panel and are caught and fastened on an upper surface of the mounting panel.

### [Advantageous Effects]

A condensing panel assembly and a heat dissipation device including the same according to the present disclosure have the effect of preventing physical shaking caused by an increase in internal pressure during gas-liquid circulation of a refrigerant, and achieving a shorter gas-liquid circulation cycle.

In addition, there is an effect in that the condensing panel assembly may be manufactured with a reduced thickness so that substantially all of the heat generated from heating elements is used only to the gas-liquid change (phase change) of a refrigerant, which substantially performs a heat dissipation function.

In addition, a condensing panel assembly and a heat dissipation device including the same according to the present disclosure have the effect of maximizing heat dissipation performance by rapidly inducing the collection and transfer of a liquid refrigerant, condensed from a gas refrigerant, to a region close to a heating element.

Effects of the present disclosure are not limited to the effects mentioned above, and other effects not mentioned above will be clearly understood by those skilled in the art from the description of the claims.

### [Description of Drawings]

FIG. 1 is a bottom perspective view and a top perspective view illustrating a heat dissipation device according to an embodiment of the present disclosure;
FIG. 2 is a bottom perspective view and a top perspective view illustrating a heat dissipation device according to another embodiment of the present disclosure;
FIG. 3 is a perspective view illustrating a condensing panel assembly according to an embodiment of the present disclosure;
FIG. 4 is an exploded perspective view of FIG. 3;
FIG. 5A is a front view (a) of FIG. 3, a cross-sectional view (b) taken along line B-B, and a partially enlarged view (c) thereof;
FIG. 5B is a front view (a) of FIG. 3, a cutaway perspective view (b) taken along line B-B, and a partially enlarged view (c) thereof;
FIG. 6 is a perspective view illustrating a condensing panel assembly according to another embodiment of the present disclosure;
FIG. 7 is an exploded perspective view of FIG. 6;
FIG. 8 is a front view (a) of FIG. 6, a cross-sectional view (b) taken along line A-A, and a cutaway perspective view (c) thereof;

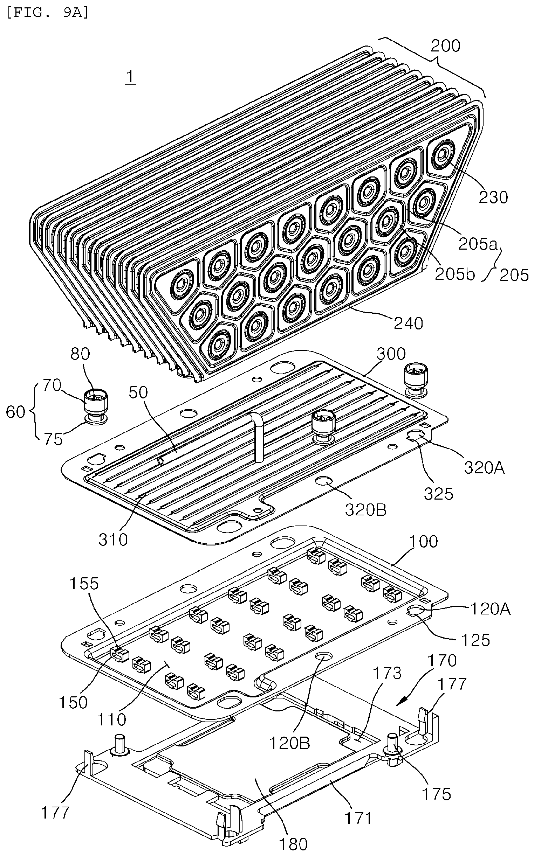

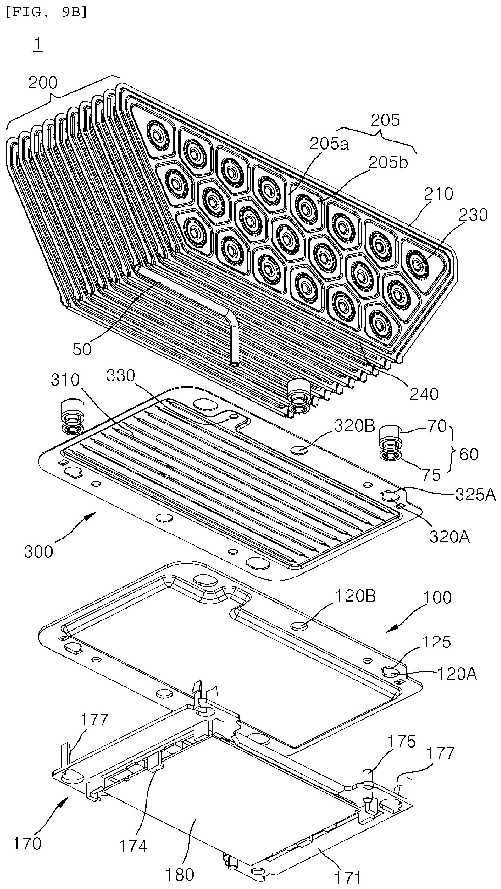

FIGS. 9A and 9B are exploded perspective views of FIG. 1;
FIG. 10 is an exploded perspective view illustrating a condensing panel assembly according to a first implementation, separated from an evaporation panel assembly in the configuration of FIG. 1;
FIG. 11 is a perspective view illustrating a state in which a single condensing panel assembly according to the first implementation is coupled to the evaporation panel assembly;
FIG. 12 is an exploded perspective view of FIG. 11;
FIG. 13 is an exploded perspective view illustrating the configuration of the condensing panel assembly according to the first implementation of FIG. 1, with the other-side heat conduction panel separated;
FIG. 14 is a perspective view illustrating a state in which a single condensing panel assembly according to the first implementation is coupled to the evaporation panel assembly in the heat dissipation device of FIG. 1, with the other-side heat conduction panel removed;
FIG. 15 is a perspective view illustrating the evaporation panel assembly in the configuration of FIG. 1;
FIG. 16 is an exploded perspective view illustrating the configuration of FIG. 15 with a mounting panel separated;
FIG. 17 is an exploded perspective view illustrating the configuration of FIG. 15 with the mounting panel and a heat transfer plate assembly separated;
FIG. 18 is a perspective view illustrating the configuration of FIG. 15 with the mounting panel removed;
FIG. 19 is an exploded perspective view illustrating one row of a plurality of rigid reinforcing members of FIG. 16;
FIG. 20 is an exploded perspective view illustrating a condensing panel assembly according to a second implementation in the configuration of FIG. 2, separated from the evaporation panel assembly;
FIG. 21 is an exploded perspective view of FIG. 20;
FIG. 22 is an exploded perspective view illustrating the configuration of the condensing panel assembly according to the second implementation of FIG. 20, with the other-side heat conduction panel separated;
FIG. 23 is a perspective view illustrating a state in which a single condensing panel assembly according to the second implementation in the configuration of the heat dissipation device of FIG. 20 is coupled to the evaporation panel assembly, with the mounting panel removed;
FIG. 24 is an exploded perspective view illustrating the evaporation panel assembly with the mounting panel separated therefrom;
FIG. 25 is an exploded perspective view illustrating a configuration in which the mounting panel and a plurality of rigid reinforcing members are separated;
FIG. 26 is a perspective view illustrating the configuration of FIG. 24 with the mounting panel removed;
FIG. 27 is an exploded perspective view illustrating one of the plurality of rigid reinforcing members of FIG. 24, separated therefrom;
FIG. 28 is a cross-sectional view taken along line A'-A' of FIG. 1;
FIG. 29A is a front view (a) of FIG. 2 and a cross-sectional view (b) taken along line B'-B'; and
FIG. 29B is a front view (a) of FIG. 2 and a cross-sectional view (b) taken along line C'-C'.

**<Description of reference numerals>**

| | | | |
|---|---|---|---|
| 1, 2: | Heat Dissipation Device | 50: | Air Vent Tube |
| 60: | Screw Boss | 70: | Locking boss |
| 75: | Fastening Boss | 80: | Mounting Screw |
| 100: | Evaporation panel Assembly | 110: | Reservoir |
| 120A, 120B: | Screw Assembly Holes | 120A: | FirstAssembly Hole |
| 120B: | Second Assembly Hole | 125: | Extension Hole |
| 130: | Vacuum Groove | 150, 150': | Rigid ReinforcingMembers |
| 170: | Heat Transfer Plate Assembly | 171: | Coupling Frame |
| 174: | Panel Fixing Hook | 175: | Guide Pin |
| 177: | Support Hook Portion | 200, 202: | Condensing Panel Assembly |
| 200A, 202A: | One-Side Heat Conduction Panel | 200B,202B: | Other-Side Heat Conduction Panel |
| 205: | Refrigerant Flow Space | 210: | Peripheral Edge |
| 205a: | First Refrigerant Flow Path | 205b: | SecondRefrigerant Flow Path |
| 230: | Strength Reinforcing Portion | 240: | Lower End |
| 250: | Absorber | 300: | Mounting Panel |
| 310: | Installation Slit | 320A, 320B: | Screw Fastening Holes |
| 320A: | First Fastening Hole | 320B: | Second Fastening Hole |
| 325: | Extension Hole | | |

### [Mode for Invention]

Hereinafter, a heat dissipation device according to an embodiment of the present disclosure will be described in detail with reference to the accompanying drawings.

It is to be noted that in assigning reference numerals to elements in the drawings, the same reference numerals denote the same elements as much as possible even in cases where the elements are shown in different drawings. Furthermore, in describing the embodiments of the present disclosure, a detailed description of the known configurations or functions will be omitted if it is deemed to obscure the understanding for the embodiments of the present disclosure.

In describing the elements of an embodiment of the present disclosure, terms, such as the first, the second, A, B, (a), and (b) may be used. However, the terms are used only to distinguish one element from the other element, and the essence, order, or sequence of the elements is not limited by the terms. Furthermore, unless otherwise defined, all terms used herein including technical or scientific terms have the same meanings as generally understood by those skilled in the art to which the present disclosure pertains. The terms, such as terms defined in dictionaries, which are generally used, should be construed as having meanings identical to contextual meanings of the related art, and are not construed as having ideal or excessively formal meanings unless they are definitely defined in the present disclosure.

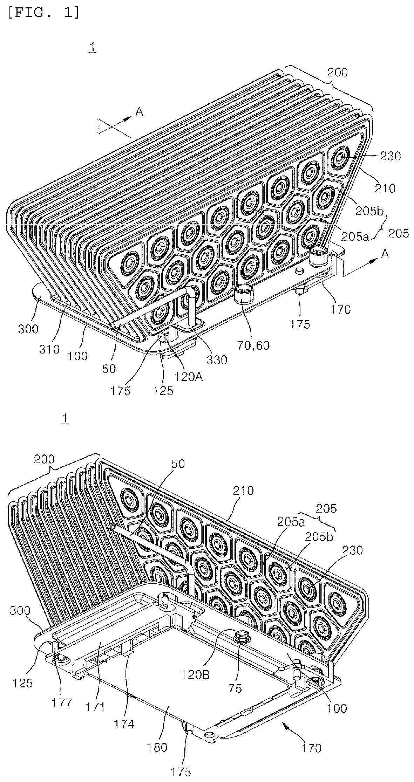

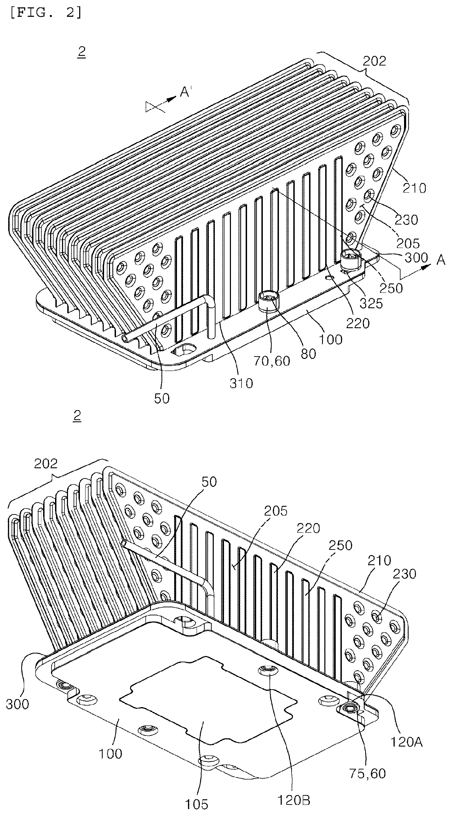

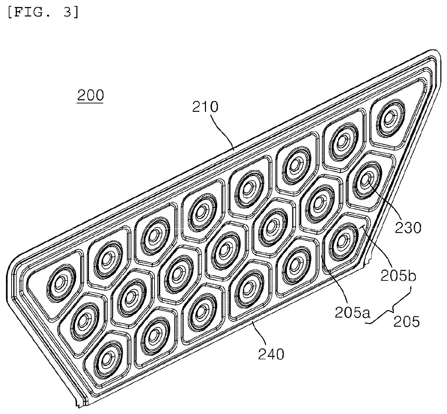

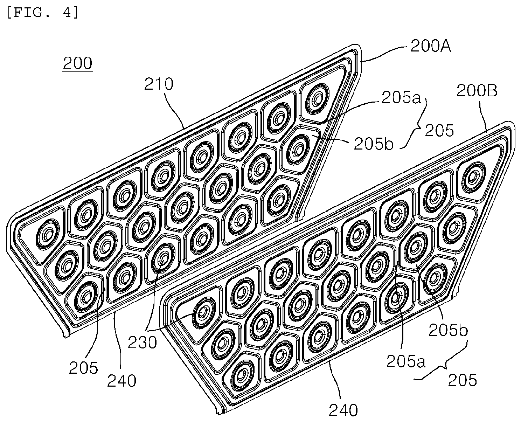

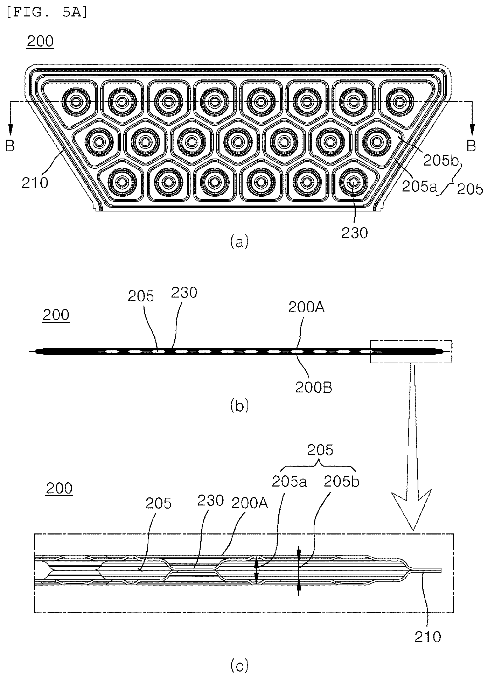

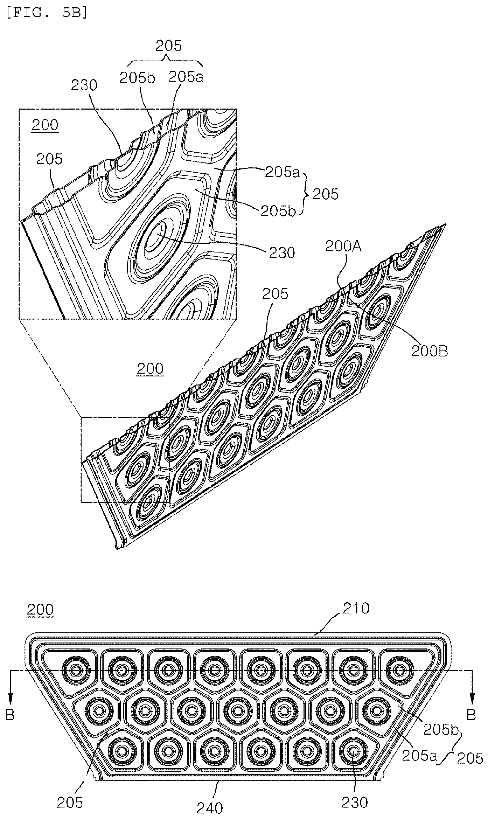

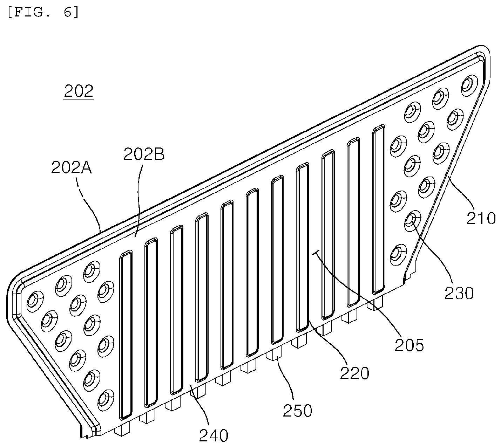

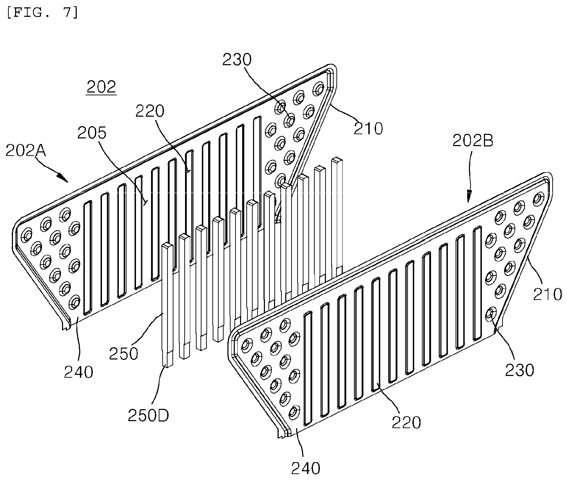

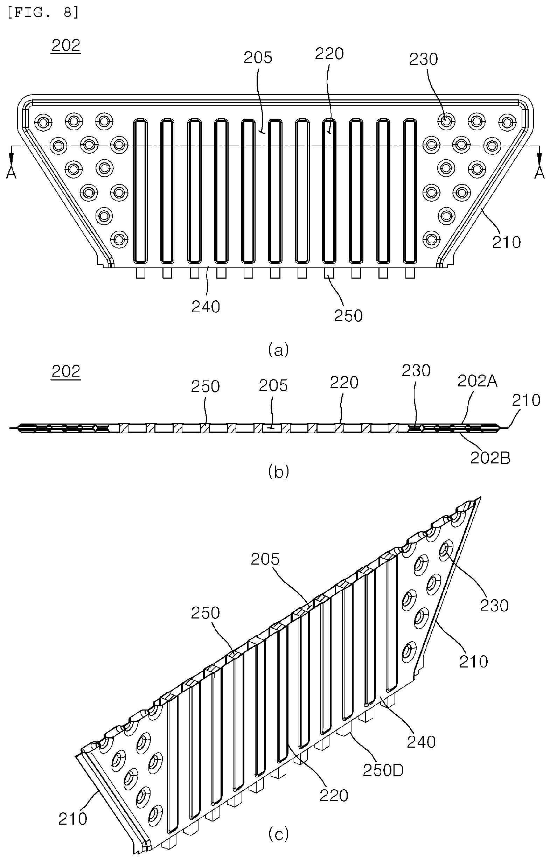

FIG. 1 is a bottom perspective view and a top perspective view illustrating a heat dissipation device according to an embodiment of the present disclosure, FIG. 2 is a bottom perspective view and a top perspective view illustrating a heat dissipation device according to another embodiment of the present disclosure, FIG. 3 is a perspective view illustrating a condensing panel assembly according to an embodiment of the present disclosure, FIG. 4 is an exploded perspective view of FIG. 3, FIG. 5A is a front view (a) of FIG. 3, a cross-sectional view (b) taken along line B-B, and a partially enlarged view (c) thereof, FIG. 5B is a front view (a) of FIG. 3, a cutaway perspective view (b) taken along line B-B, and a partially enlarged view (c) thereof, FIG. 6 is a perspective view illustrating a condensing panel assembly according to another embodiment of the present disclosure, FIG. 7 is an exploded perspective view of FIG. 6, and FIG. 8 is a front view (a) of FIG. 6, a cross-sectional view (b) taken along line A-A, and a cutaway perspective view (c) thereof.

As illustrated in FIGS. 1 to 8, a heat dissipation device 1 according to an embodiment of the present disclosure includes an evaporation panel assembly 100 that is in surface thermal contact with a heat-generating surface of a heating element (not shown) and has a reservoir 110 in which a liquid refrigerant is stored, a plurality of condensing panel assemblies 200, 202 that are coupled to the evaporation panel assembly 100 and in which a gas refrigerant phase-changed in the reservoir diffuses and condenses, and a mounting panel 300 configured to mediate slit coupling between the evaporation panel assembly 100 and the condensing panel assemblies 200 and 202.

Here, the evaporation panel assembly 100 may be made of copper (Cu), and the condensing panel assemblies 200 and 202 may be made of stainless steel (SUS).

Further, the plurality of condensing panel assemblies 200, 202 may form a refrigerant flow space 205, in which a liquid refrigerant and a gas refrigerant flow, by bonding peripheral edges 210 of a one-side heat conduction panel 200A, 202A and an other-side heat conduction panel 200B, 202B, which are two base panels made of SUS, and a plurality of strength reinforcing portions 230 formed on surfaces thereof.

In the plurality of condensing panel assemblies 200, 202, a plurality of refrigerant flow paths 205a, 205b, through which the liquid refrigerant flows in a gravity direction, are formed, and each of the plurality of refrigerant flow paths 205a, 205b may be provided with an absorber 250 formed of a braided wire mesh.

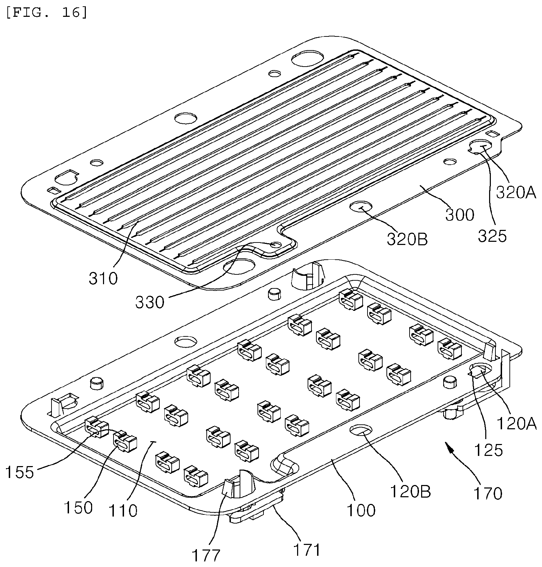

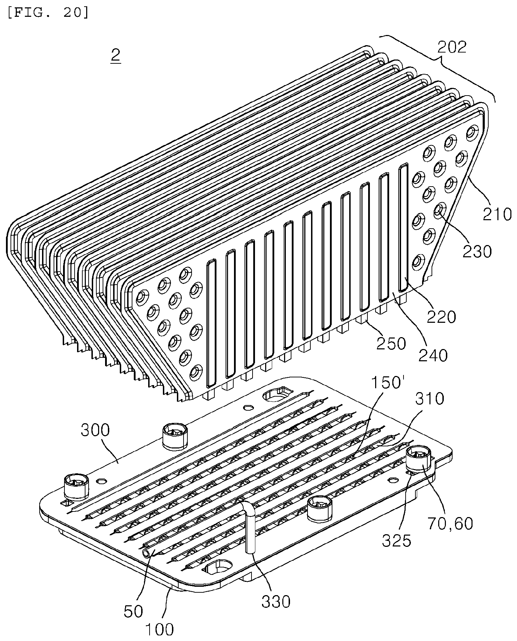

Here, a plurality of strength reinforcing members (see reference numeral 150 in FIG. 16 and reference numeral 150' in FIG. 20, described later) for reinforcing strength between the evaporation panel assembly 100 and the above-described mounting panel 300 may be coupled to the evaporation panel assembly 100 by a brazing method.

Meanwhile, the mounting panel 300 may be formed with a plurality of installation slits 310 into which lower ends of the plurality of condensing panel assemblies 200, 202 are fitted and coupled.

The evaporation panel assembly 100 may be further provided with an air vent tube 50 for filling a refrigerant or for evacuating the refrigerant flow space 205 before or after injection of the refrigerant.

The heat dissipation device 1 according to the embodiment of the present disclosure described above may be implemented as specific embodiments, such as heat dissipation devices 1, 2 according to another embodiment and still another embodiment of the present disclosure described later.

First, as illustrated in FIGS. 1 and 2, the heat dissipation devices 1 and 2 according to other embodiments of the present disclosure may include an evaporation panel assembly 100 in which a reservoir (see reference numeral 110 in FIG. 3 and subsequent drawings) is formed to store a refrigerant capable of phase change depending on temperature, and at least a portion of a lower surface is in surface thermal contact with heat-generating surfaces of heating elements (not shown), and a plurality of condensing panel assemblies 200, 202 coupled to the evaporation panel assembly 100 to communicate with the reservoir 110 and configured to dissipate heat transferred from the heating elements through heat exchange with outside air (outdoor air).

Here, the heat dissipation devices 1 and 2 of the present disclosure may be classified into one embodiment 1 as illustrated in FIG. 1 and another embodiment 2 as illustrated in FIG. 2. The criterion for this classification may be determined according to whether the absorber 250 is present in the refrigerant flow space 205 formed by the one-side heat conduction panel 200A, 202A and the other-side heat conduction panel 200B, 202B, which will be described later.

That is, as illustrated in FIGS. 3 to 5B below, an embodiment including a condensing panel assembly 200 according to a first implementation, which is configured so that the condensation of the refrigerant occurs without the provision of the absorber 250 in the refrigerant flow space 205, may be defined as a heat dissipation device 1 according to another embodiment. Conversely, as illustrated in FIGS. 6 to 8 below, an embodiment including a condensing panel assembly 202 according to a second implementation, which is configured so that the condensation of the refrigerant occurs with the absorber 250 provided in the refrigerant flow space 205, may be defined as a heat dissipation device 2 according to still another embodiment.

As illustrated in FIGS. 1 and 2, the plurality of condensing panel assemblies 200, 202 according to embodiments of the present disclosure are coupled to the evaporation panel assembly 100 to constitute the heat dissipation device 1, 2.

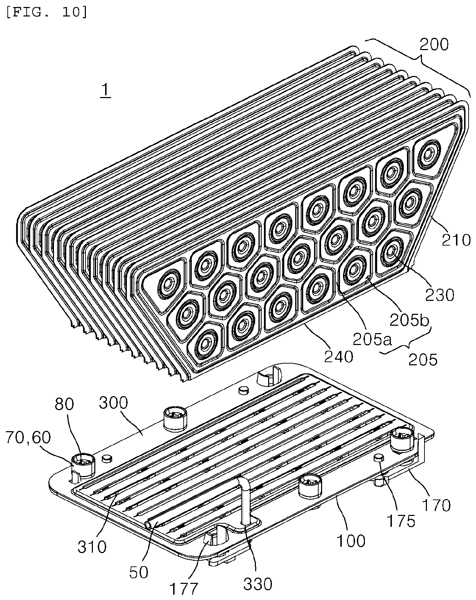

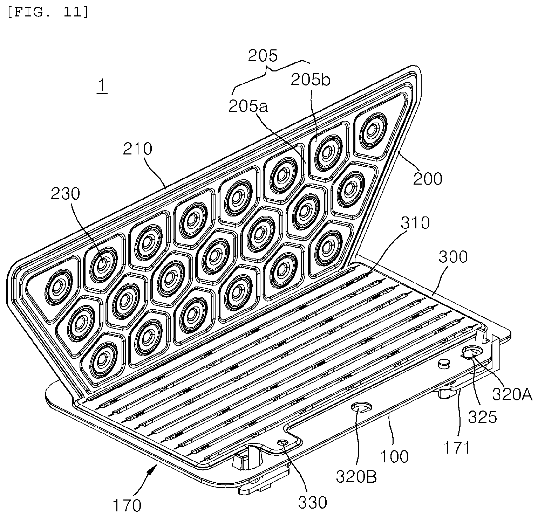

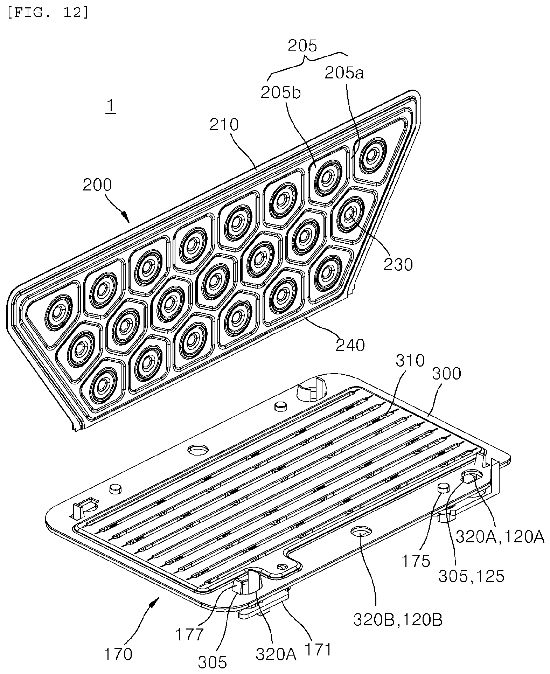

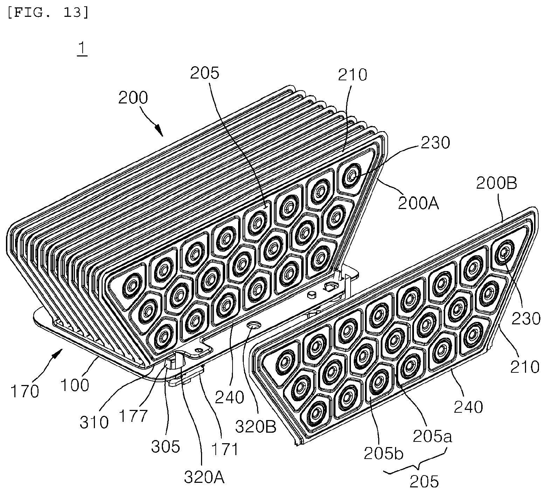

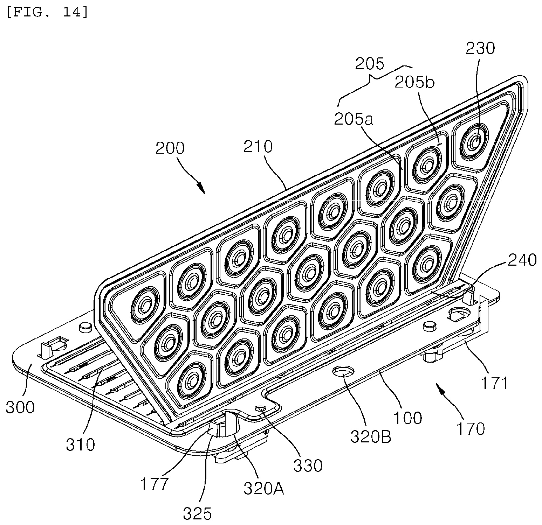

FIG. 10 is an exploded perspective view illustrating the condensing panel assembly according to the first implementation, separated from the evaporation panel assembly in the configuration of FIG. 1, FIG. 11 is a perspective view illustrating a state in which a single condensing panel assembly according to the first implementation is coupled to the evaporation panel assembly, FIG. 12 is an exploded perspective view of FIG. 11, FIG. 13 is an exploded perspective view illustrating the configuration of the condensing panel assembly according to the first implementation of FIG. 1, with the other-side heat conduction panel separated, and FIG. 14 is a perspective view illustrating a state in which a single condensing panel assembly according to the first implementation is coupled to the evaporation panel assembly in the heat dissipation device of FIG. 1, with the other-side heat conduction panel removed.

Hereinafter, a heat dissipation device 1 according to an embodiment of the present disclosure will first be described in detail.

As illustrated in FIGS. 10 to 14, the heat dissipation device 1 according to an embodiment of the present disclosure includes an evaporation panel assembly 100 that is in surface thermal contact with a heat-generating surface of a heating element (not shown) and has a reservoir 110 in which a liquid refrigerant is stored, and a plurality of condensing panel assemblies 200 that are coupled to the evaporation panel assembly 100 and in which a gas refrigerant phase-changed in the reservoir 110 diffuses and condenses.

Hereinafter, a condensing panel assembly 200 included in a heat dissipation device 1 according to another embodiment of the present disclosure will be defined and described as a condensing panel assembly 200 according to a first implementation.

Conversely, a condensing panel assembly 202 included in a heat dissipation device 2 according to still another embodiment of the present disclosure will be defined and described as a condensing panel assembly 202 according to a second implementation.

Here, the evaporation panel assembly 100 may serve to receive heat from heat-generating surfaces of heating elements (not shown) that inevitably generate heat while being electrically driven, such as electronic devices, and to evaporate a liquid refrigerant stored in the reservoir 110 into a gas refrigerant.

In addition, as will be described later, the condensing panel assembly 200 according to the first implementation may be provided to communicate with the reservoir 110 of the evaporation panel assembly 100 via the mounting panel 300, and may serve to release to the outside the heat supplied from the heating elements through heat exchange with outside air (outdoor air) during a process in which the gas refrigerant phase-changed in the evaporation panel assembly 100 diffuses and flows and is then condensed again into the liquid refrigerant.

More specifically, as illustrated in FIGS. 10 to 14, the evaporation panel assembly 100 may have the reservoir 110 formed in the shape of a groove having a predetermined depth so as to have a substantially rectangular horizontal cross-section at a central portion of an upper surface thereof.

Here, the liquid refrigerant is stored in the reservoir 110, and an upper open portion thereof may be shielded by the mounting panel 300, which will be described later, that mediates coupling of the condensing panel assembly 200 according to the first implementation to the evaporation panel assembly 100.

That is, the condensing panel assembly 200 according to the first implementation may be coupled to the evaporation panel assembly 100 via the mounting panel 300. Here, when the evaporation panel assembly 100 is provided in the form of a substantially rectangular panel with rounded corners, the mounting panel 300 may also be provided in a panel shape capable of entirely covering an upper surface of the evaporation panel assembly 100.

The mounting panel 300 may be provided to cover the reservoir 110 of the evaporation panel assembly 100 and may serve to allow portions of the plurality of condensing panel assemblies 200 to be inserted and supported.

For this purpose, the mounting panel 300 may be formed with a plurality of installation slits 310, into which the plurality of condensing panel assemblies 200 are individually inserted, the slits being elongated in a longitudinal direction and cut so as to communicate with the reservoir 110 and the refrigerant flow spaces 205 of the plurality of condensing panel assemblies 200 according to the first implementation.

A plurality of screw assembly holes 120A and 120B and a plurality of screw fastening holes 320A and 320B for being assembled to each other through mounting screws 80, which will be described later, may be formed in the peripheral edges of the evaporation panel assembly 100 and the mounting panel 300, respectively.

More specifically, the plurality of screw assembly holes 120A and 120B may include first assembly holes 120A formed to penetrate in a vertical direction at one longitudinal end and the other longitudinal end among the peripheral edges of the evaporation panel assembly 100, and second assembly holes 120B formed to penetrate in a vertical direction at central portions of widthwise ends among the peripheral edges of the evaporation panel assembly 100.

In addition, the plurality of screw fastening holes 320A and 320B may be formed in the mounting panel 300, and may include first fastening holes 320A formed to penetrate in a vertical direction at positions corresponding to the first assembly holes 120A of the evaporation panel assembly 100 described above, and second fastening holes 320B formed to penetrate in a vertical direction at positions corresponding to the second assembly holes 120B of the evaporation panel assembly 100.

Here, the mounting screws 80 may be fastened via screw bosses 60 that are coupled to the plurality of screw assembly holes 120A and 120B and the plurality of screw fastening holes 320A and 320B.

The screw boss 60 may include a locking boss 70 that is engaged with edge portions of the plurality of screw fastening holes 320A and 320B from an upper side of the mounting panel 300 and that allows at least a head portion of the mounting screw 80 to be caught therein when the mounting screw 80 passes therethrough, and a fastening boss 75 that is inserted from a lower side of the evaporation panel assembly 100 so as to pass through the plurality of screw assembly holes 120A and 120B and that has an internal female thread for engaging with a male thread formed on an outer circumference of a shank of the mounting screw 80.

A coupling process of the mounting panel 300 to the evaporation panel assembly 100 using the mounting screws 80 will be briefly described as follows.

First, after inserting and positioning the fastening bosses 75 into the plurality of screw assembly holes 120A and 120B formed in the evaporation panel assembly 100, the locking bosses 70 are placed at positions where the plurality of screw fastening holes 320A and 320B are formed in the mounting panel 300, and then the mounting screws 80 are rotationally fastened from and upper side of the locking bosses 70.

At this time, male threads of the mounting screw 80 are engaged with female threads formed inside the fastening boss 75 to achieve fastening, and the head portion of the mounting screw 80 is caught within the locking boss 70, thereby increasing adhesion or coupling force of the mounting panel 300 to an upper surface of the evaporation panel assembly 100.

Meanwhile, among the plurality of screw fastening holes 320A and 320B, the first fastening holes 320A, and among the plurality of screw assembly holes 120A and 120B, the first assembly holes 120A may each be formed to have a diameter that allows at least the fastening boss 75 to be inserted but prevents the locking boss 70 from being inserted. Extension holes 325 and 125 may be formed to communicate with one side of the first fastening hole 320A and the first assembly hole 120A so as to allow movement in one direction while at least the fastening boss 75 is inserted.

For reference, the extension holes 325 and 125 formed in the mounting panel 300 and the evaporation panel assembly 100 may serve to allow a support hook portion 177 of a heat transfer plate assembly 170, which will be described later, to be inserted and engaged therein. This will be described in more detail later.

The evaporation panel assembly 100 and the mounting panel 300 coupled by the mounting screw 80 may be sealed so that the liquid refrigerant (or gas refrigerant) stored in the internal reservoir 110 does not leak.

In addition, at least one location among peripheral edges of the evaporation panel assembly 100 may be further machined to form a vacuum groove 130 in a groove shape for communicative installation of the air vent tube 50 to be described later. The vacuum groove 130 may be formed to communicate with the reservoir 110.

Meanwhile, at least one location among peripheral edges of the mounting panel 300, corresponding to the position of the vacuum groove 130 of the evaporation panel assembly 100, may be formed with a tube installation hole 330 penetrating so as to communicate with the vacuum groove 130 for fixed installation of the air vent tube 50 to be described later.

In the heat dissipation device 1 according to embodiments of the present disclosure, when a phase-change refrigerant is filled inside as in the condensing panel assembly 200 according to the first implementation, the evacuating process for evacuating the refrigerant flow space 205 is essential so as to correspond to variations in internal pressure generated during the phase change. The above-described evacuating process may be performed through the air vent tube 50 coupled via the vacuum groove 130 of the evaporation panel assembly 100 and the tube installation hole 330 of the mounting panel 300.

After the evacuating process is completed, an air tube caulking process may be performed to block communication with the outside after cutting off the air vent tube 50. However, the air vent tube 50 does not necessarily have to be cut off, and it is sufficient to perform a caulking process so as to block the air flow path of the air vent tube 50.

Meanwhile, as illustrated in FIGS. 10 to 19, the heat dissipation device 1 according to another embodiment of the present disclosure may further include a heat transfer plate assembly 170 coupled so as to receive heat from heating elements (not shown) and transfer the heat to a lower surface of the evaporation panel assembly 100. The specific configuration and structure of the heat transfer plate assembly 170 will be described in more detail below.

The lower surface of the heat transfer plate assembly 170 is preferably arranged to be in complete contact with heat-generating surfaces of the heating elements without any gap. For this purpose, it is natural that a heat transfer material (not shown) may be applied therebetween.

Meanwhile, in the heat dissipation device 1 according to another embodiment of the present disclosure, the condensing panel assembly 200 according to the first implementation, which is coupled to an upper surface of the evaporation panel assembly 100 via the mounting panel 300, may include a one-side heat conduction panel 200A and an other-side heat conduction panel 200B, as illustrated in FIGS. 3 to 5B.

Here, the one-side heat conduction panel 200A and the other-side heat conduction panel 200B may each be a metal panel member having at least a predetermined level of thermal conductivity and may be formed by sheet-metal processing through a press forming process.

More specifically, the one-side heat conduction panel 200A and the other-side heat conduction panel 200B may be formed by subjecting a base metal panel member to the above-described press forming process so as to be sheet-metal processed into a trapezoidal shape in which an upper side and a lower side are parallel to each other, and a length of the lower side coupled to the evaporation panel assembly 100 is smaller than a length of the upper side.

That is, the one-side heat conduction panel 200A and the other-side heat conduction panel 200B may be coupled so as to protrude upward while being orthogonal to an upper surface of the evaporation panel assembly 100, and as the internal refrigerant flow space 205 gradually widens toward the top, a heat dissipation area with outside air (outdoor air) may gradually increase.

In addition, in the one-side heat conduction panel 200A and the other-side heat conduction panel 200B, peripheral edges 210 for mutual bonding, a plurality of strength reinforcing portions 230 to be described later, and a first refrigerant flow path 205a and a second refrigerant flow path 205b, which are detailed configurations of the refrigerant flow space 205, may be simultaneously formed during sheet-metal processing according to the press forming process.

More specifically, the one-side heat conduction panel 200A and the other-side heat conduction panel 200B may be sheet-metal processed into mutually symmetrical shapes through the above-described press forming process, and then may be bonded at their respective peripheral edges 210, except for lower end portions coupled to the evaporation panel assembly 100, through a joining process, thereby forming the refrigerant flow space 205 therein.

Meanwhile, the refrigerant flow space 205 may be formed to have a maximum separation distance between the one-side heat conduction panel 200A and the other-side heat conduction panel 200B, that is, to be maximally spaced apart in a thickness direction of the refrigerant flow space 205, and may include a first refrigerant flow path 205a formed so as to surround each of a plurality of strength reinforcing portions 230 to be described later, and a second refrigerant flow path 205b formed between each of the plurality of strength reinforcing portions 230 to be described later and the first refrigerant flow path 205a, the second refrigerant flow path being formed by recessing the one-side heat conduction panel 200A and the other-side heat conduction panel 200B toward the refrigerant flow space 205 side.

More specifically, the one-side heat conduction panel 200A and the other-side heat conduction panel 200B may be bonded to each other, through a joining process, at the peripheral edges 210 and the plurality of strength reinforcing portions 230 that are simultaneously formed during sheet-metal processing through the press forming process, so that the refrigerant flow space 205 may be sealed except for a lower end that is a coupling portion to the evaporation panel assembly 100. In this case, the joining process may include a welding method, and the welding method may include laser welding.

Meanwhile, the plurality of strength reinforcing portions 230 may be formed, during sheet-metal processing through the press forming process, to be recessed in a dot shape or an elliptical shape from an outer side of the one-side heat conduction panel 200A and the other-side heat conduction panel 200B toward an inner side where the refrigerant flow space 205 is formed. In the condensing panel assembly 200 according to the first implementation, the plurality of strength reinforcing portions 230 may be formed so as to be uniformly spaced over an entire area of the one-side heat conduction panel 200A and the other-side heat conduction panel 200B.

Here, the plurality of strength reinforcing portions 230 may be formed at mutually symmetrical positions on the one-side heat conduction panel 200A and the other-side heat conduction panel 200B, and may be provided such that recessed portions in the refrigerant flow space 205 are in surface contact with each other, and the surface-contacting portions may be joined by a welding method including laser welding.

The plurality of strength reinforcing portions 230 formed as described above may also serve to reinforce inherent rigidity of the one-side heat conduction panel 200A and the other-side heat conduction panel 200B during sheet-metal processing by the press forming process.

Here, a recessed depth of the second refrigerant flow paths 205b respectively formed in the one-side heat conduction panel 200A and the other-side heat conduction panel 200B toward the refrigerant flow space 205 may be formed to be spaced apart from each other in a thickness direction within the refrigerant flow space 205.

Preferably, the recessed depth of the second refrigerant flow paths 205b may be formed to be greater than at least a recessed depth of the first refrigerant flow path 205a and smaller than the plurality of strength reinforcing portions 230.

In particular, the first refrigerant flow path 205a may be understood as corresponding to a basic base surface that is a portion not pressed during sheet-metal processing of the one-side heat conduction panel 200A and the other-side heat conduction panel 200B by the press forming process.

Such a first refrigerant flow path 205a serves to guide flow of the liquid refrigerant toward the reservoir 110 of the evaporation panel assembly 100 located below in a gravity direction when the liquid refrigerant in the reservoir 110 of the evaporation panel assembly 100 evaporates and phase-changes into a gas refrigerant, diffuses and flows into the refrigerant flow space 205, and is then condensed again through heat exchange with outside air (outdoor air) to phase-change back into the liquid refrigerant.

Therefore, the first refrigerant flow path 205a is preferably patterned so as to be inclined or vertical so that flow resistance does not occur when flowing downward in the gravity direction.

Meanwhile, the second refrigerant flow path 205b may serve to allow the gas refrigerant evaporated in the reservoir 110 of the evaporation panel assembly 100 to be easily diffused and dispersed. That is, since the flow of the liquid refrigerant is generally guided through the first refrigerant flow path 205a, the gas refrigerant may more actively flow, diffuse, and disperse through the second refrigerant flow path 205b, which has a smaller size in the thickness direction than the first refrigerant flow path 205a, thereby making it possible to shorten the overall gas-liquid circulation cycle.

Here, the second refrigerant flow path 205b may be formed so as to be distinguished from the first refrigerant flow path 205a with respect to each of the plurality of strength reinforcing portions 230.

More specifically, when the plurality of strength reinforcing portions 230 are arranged to have a uniform spacing distance over an entire area of the one-side heat conduction panel 200A and the other-side heat conduction panel 200B, and when defined as being formed in a dot shape recessed toward the refrigerant flow space 205, the second refrigerant flow path 205b may be recessed and formed in a predetermined pattern shape so as to surround a periphery of each strength reinforcing portion 230.

Here, the pattern shape of the second refrigerant flow path 205b may include any of a hexagonal shape, a pentagonal shape, or a quadrangular shape, and is preferably selected to be a shape that does not affect the inclined shape of the first refrigerant flow path 205a described above.

Meanwhile, the first refrigerant flow path 205a may be formed in a pattern shape in which respective pattern shapes of the above-described second refrigerant flow paths 205b are distinguished from each other.

Referring to FIGS. 10 to 14, a manufacturing method of the condensing panel assembly 202 according to an embodiment of the present disclosure will be briefly described as follows.

First, as a base metal panel member, preferably made of SUS, the one-side heat conduction panel 200A and the other-side heat conduction panel 200B may be formed and manufactured by sheet-metal processing through a press forming process so that left and right portions are mutually symmetrical with respect to a middle portion in a longitudinal direction.

In particular, during the press forming process, the refrigerant flow space 205 may be formed inside the one-side heat conduction panel 200A and the other-side heat conduction panel 200B with a predetermined thickness, and the peripheral edges 210 may be simultaneously processed and formed to be joined to each other such that the refrigerant flow space 205 is closed except for the lower end 240 coupled to the evaporation panel assembly 100.

In addition, during the press forming process, the plurality of strength reinforcing portions 230 for mutually bonding the one-side heat conduction panel 200A and the other-side heat conduction panel 200B by the welding method within the refrigerant flow space 205 therebetween may be simultaneously processed and formed. Moreover, respective pattern shapes of the first refrigerant flow paths 205a and the second refrigerant flow paths 205b formed around each of the plurality of strength reinforcing portions 230 may also be simultaneously processed and formed.

After the above-described peripheral edges 210, strength reinforcing portions 230, first refrigerant flow paths 205a and second refrigerant flow paths 205b are formed through the press forming process, the peripheral edges 210 and the strength reinforcing portions 230 of the one-side heat conduction panel 200A and the other-side heat conduction panel 200B may be joined by the welding method through the joining process, thereby forming the refrigerant flow space 205 therein.

Meanwhile, the condensing panel assembly 200 according to the first implementation manufactured through the process described above may be installed such that its lower end 240 is immersed in the reservoir 110 of the evaporation panel assembly 100, as illustrated in FIGS. 13 and 14.

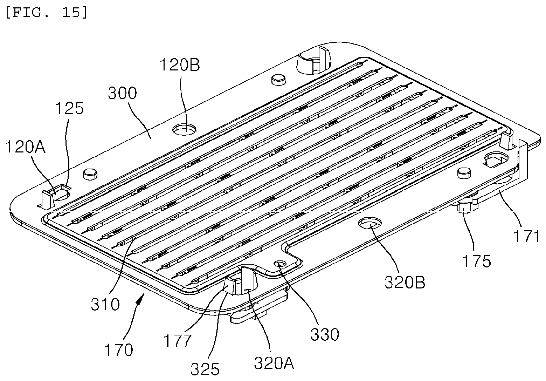

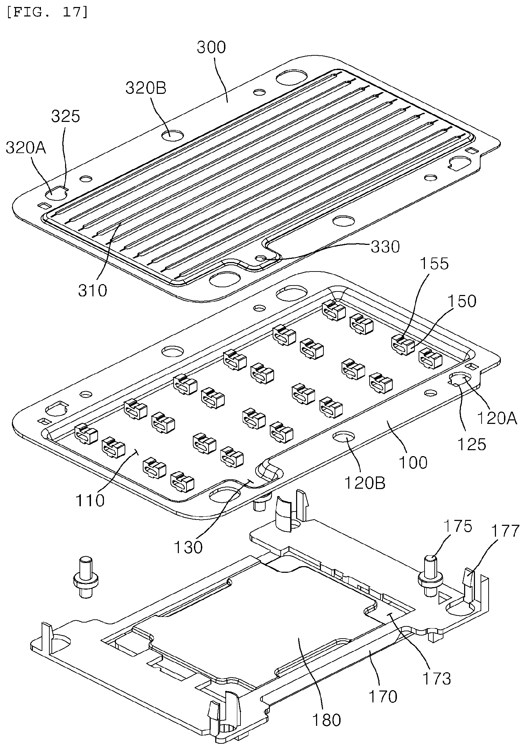

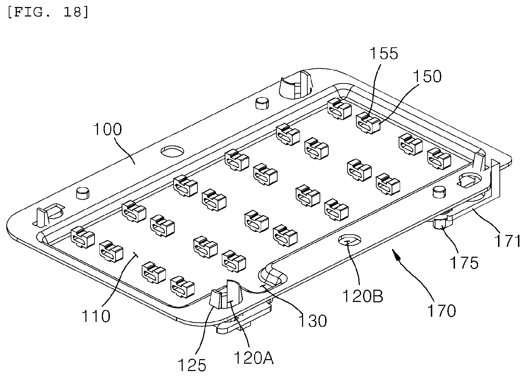

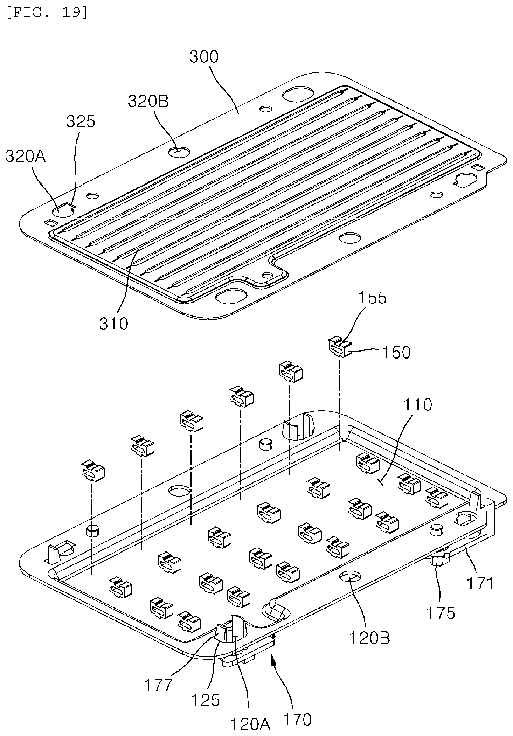

FIG. 15 is a perspective view illustrating the evaporation panel assembly in the configuration of FIG. 1, FIG. 16 is an exploded perspective view illustrating the configuration of FIG. 15 with the mounting panel separated, FIG. 17 is an exploded perspective view illustrating the configuration of FIG. 15 with the mounting panel and the heat transfer plate assembly separated, FIG. 18 is a perspective view illustrating the configuration of FIG. 15 with the mounting panel removed, and FIG. 19 is an exploded perspective view illustrating one row of a plurality of rigid reinforcing members of FIG. 16.

A more detailed description of the evaporation panel assembly 100 in which the condensing panel assembly 200 according to the first implementation is installed will be provided as follows.

As illustrated in FIGS. 15 to 19, the evaporation panel assembly 100 may be provided to be in surface thermal contact with heat-generating surfaces of respective heating elements, and may serve as a heat sink that phase-changes a liquid refrigerant stored in the internal reservoir 110 into a gas refrigerant by heat supplied from the heating elements.

To this end, the evaporation panel assembly 100 may be made of a metal material having excellent thermal conductivity. Preferably, the evaporation panel assembly 100 may be made of copper (Cu), and, except for the peripheral edges for coupling with the mounting panel 300, a portion in which the reservoir 110 directly receiving heat from the heating elements is formed may be formed to have a thickness as thin as possible.

Meanwhile, in the mounting panel 300 that covers an upper surface of the reservoir 110 of the evaporation panel assembly 100, a plurality of installation slits 310 for spaced installation of the plurality of condensing panel assemblies 200 may be formed to penetrate therethrough in a vertical direction.

More specifically, when the mounting panel 300 is provided as a rectangular metal panel member elongated in a left-right direction, and the lower ends 240 of the condensing panel assemblies 200 are installed to extend in the left-right direction, the plurality of installation slits 310 may be formed to be spaced apart in a width direction defined as a front-rear direction.

In an embodiment of the present disclosure, the description will be limited to the heat dissipation device 1 in which eight condensing panel assemblies 200 are respectively coupled lengthwise in the left-right direction on an upper surface of a single evaporation panel assembly 100 and are arranged to be spaced apart from each other by a predetermined distance in a width direction.

Here, a portion of the evaporation panel assembly 100 that forms the reservoir 110 is a metal panel member made of copper (Cu) and thus has very low strength (hardness), so a plurality of rigid reinforcing members 150 for reinforcing the same may be installed in the reservoir 110.

As illustrated in FIGS. 15 to 19, the plurality of rigid reinforcing members 150 may be arranged to extend lengthwise roughly in a left-right direction of the reservoir 110 and to be disposed in a plurality of rows.

More specifically, in the condensing panel assembly 200 according to the first implementation, the plurality of rigid reinforcing members 150 may be arranged such that lower surfaces thereof are seated in the reservoir 110 of the evaporation panel assembly 100 by a fixing method including welding, and may be disposed so as to form four rows in a width direction defined as a front-rear direction.

Here, the plurality of adjacent rigid reinforcing members 150 may be provided such that upper surfaces thereof are divided into two portions by division grooves 155, and each divided upper surface may be brought into contact with a lower surface corresponding to a space between the installation slits 310 of the mounting panel 300.

Here, when a total of eight condensing panel assemblies 200 according to the first implementation are installed through the mounting panel 300, eight installation slits 310 are also formed in the mounting panel 300. However, since the mounting panel 300 is provided in the form of a very thin SUS panel, there is a concern that sagging in a vertical direction may occur due to formation of the eight installation slits 310, and thus the plurality of rigid reinforcing members 150 are provided to support the same.

More specifically, the plurality of rigid reinforcing members 150 may be arranged such that four are spaced apart from each other in a width direction, and a total of eight upper surfaces divided by the division grooves 155 of the rigid reinforcing members 150 may be fixed and supported, by a fixing method including welding, to lower surfaces of the mounting panel 300 corresponding to spaces between the eight installation slits 310, thereby enabling the mounting panel 300 to be supported upward.

On each side surface of the plurality of rigid reinforcing members 150 described above, the lower ends 240 of the plurality of condensing panel assemblies 200 may be inserted to support outer side surfaces of lower ends of the one-side heat conduction panels 200A and the other-side heat conduction panels 200B respectively constituting the condensing panel assemblies 202.

More specifically, the plurality of rigid reinforcing members 150 may be arranged in multiple rows in the reservoir 110 of the evaporation panel assembly 100 to support a lower surface of the mounting panel 300 and a bottom surface of the reservoir 110, and the one-side heat conduction panel 200A and the other-side heat conduction panel 200B may be supported at one lower side surface and the other lower side surface thereof between the plurality of rigid reinforcing members 150.

In this manner, after the plurality of condensing panel assemblies 200 according to the first implementation are coupled through the respective installation slits 310 of the mounting panel 300, welding may be performed along peripheries of the installation slits 310 so as to prevent external leakage of the liquid refrigerant stored in the reservoir 110 of the evaporation panel assembly 100 or the gas refrigerant that phase-changes therefrom and diffuses and flows through the refrigerant flow space 205 of the condensing panel assemblies 200.

In this manner, the plurality of rigid reinforcing members 150 may be joined at respective lower and upper contact ends to the evaporation panel assembly 100 and the mounting panel 300, thereby serving to reinforce rigidity of respective portions of the evaporation panel assembly 100 and the mounting panel 300, which are provided with relatively thin thicknesses.

In addition, the plurality of rigid reinforcing members 150 may be positioned in the reservoir 110 of the evaporation panel assembly 100 and immersed in the stored liquid refrigerant, thereby not only indirectly serving to transfer heat supplied from the heating elements to the liquid refrigerant, but also serving to assist more active gas-liquid conversion (phase change) by increasing a heat transfer area at this time.

To this end, the plurality of rigid reinforcing members 150 may be made of a metal material having excellent thermal conductivity, and may preferably be made of SUS, which is the same material as the condensing panel assembly 200, or Cu, which is the same material as the evaporation panel assembly 100.

Meanwhile, the heat dissipation device 2 according to an embodiment of the present disclosure may further include a heat transfer plate assembly 170 that directly receives heat generated from the heating elements and mediates transfer thereof to the lower surface of the evaporation panel assembly 100, as illustrated in FIGS. 15 to 19.

In general, although a design in which the lower surface of the evaporation panel assembly 100 is in direct surface thermal contact with the heat-generating surfaces of the heating elements would be most preferable in terms of heat transfer efficiency, it may be assumed that, due to various causes, the heat-generating surfaces of the heating elements and the lower surface of the evaporation panel assembly 100 are spaced apart to such an extent that surface thermal contact is impossible.

Here, the heat transfer plate assembly 170 is disposed in a space spaced apart from the heat-generating surfaces of the heating elements described above and serves to transfer heat supplied from the heat-generating surfaces of the heating elements to the evaporation panel assembly 100 using high thermal conductivity.

As illustrated in FIG. 17, the heat transfer plate assembly 170 may include a coupling frame 171 made of a non-conductive material and provided in a substantially quadrangular frame shape, and a heat transfer panel 180 coupled to a central portion of the coupling frame 171, and having a lower surface in surface thermal contact with the heat-generating surfaces of the heating elements and an upper surface in surface thermal contact with the lower surface of the evaporation panel assembly 100.

Here, a predetermined space 173 may be formed between the coupling frame 171 and the heat transfer panel 180.

The heat transfer panel 180 may be made of gold in view of a requirement for high thermal conductivity, depending on a heat dissipation requirement for the heating elements. However, the entire panel does not necessarily have to be made of gold, and it may also be plated with gold so as to facilitate heat transfer.

Meanwhile, among the components of the heat transfer plate assembly 170, the coupling frame 171 serves as a structure for heat transfer of the above-described heat transfer panel 180 and is formed such that a center portion thereof penetrates in a vertical direction, and at least one pair of panel fixing hooks 174 for fixing the heat transfer panel 180 may be integrally formed at an inner end of the penetrated portion of the coupling frame 171.

In addition, the coupling frame 171 may be further formed with support hook portions 177 that are inserted through the extension holes 125 and 325 formed in the evaporation panel assembly 100 and the mounting panel 300 and are finally caught and fastened on the upper surface of the mounting panel 300.

Further, the heat transfer plate assembly 170 may further include at least one guide pin 175 for guiding hook coupling of the coupling frame 171 to the evaporation panel assembly 100 and the mounting panel 300.

Meanwhile, in the heat dissipation device 1 according to an embodiment of the present disclosure, the condensing panel assembly 200 according to the first implementation may further include, although not illustrated in the drawings, a plurality of condensed refrigerant collection absorbers (hereinafter abbreviated as "absorbers") provided in a condensing panel assembly 202 according to a second implementation to be described later.

Here, since the absorber may be understood as being formed in the same manner as the condensing panel assembly 202 according to the second implementation described later, a detailed description thereof will be replaced with the description of the condensing panel assembly 202 according to the second implementation.

As described above, the condensing panel assembly 200 according to the first implementation included in the heat dissipation device 1 according to another embodiment of the present disclosure has been described in detail.

Hereinafter, a heat dissipation device 2 according to still another embodiment of the present disclosure and the condensing panel assembly 202 according to the second implementation included therein will be described.

As illustrated in FIGS. 6 to 8, the condensing panel assembly 202 according to the second implementation may further include a plurality of condensed refrigerant collection absorbers 250 (hereinafter abbreviated as "absorbers") arranged in the refrigerant flow space 205 formed between the one-side heat conduction panel 202A and the other-side heat conduction panel 202B, the absorbers being elongated in a gravity direction and arranged so as to be supported while simultaneously contacting an inner surface of the one-side heat conduction panel 202A forming one heat dissipation surface of the refrigerant flow space 205 and an inner surface of the other-side heat conduction panel 202B forming the other heat dissipation surface of the refrigerant flow space 205.

Here, the absorber 250, in the reservoir 110 of the evaporation panel assembly 100, serves to collect liquid refrigerant condensed from a gas refrigerant, after the gas refrigerant phase-changed from a liquid refrigerant state diffuses and flows into the refrigerant flow space 205 between the one-side heat conduction panel 202A and the other-side heat conduction panel 202B and undergoes heat exchange with outside air (outdoor air), and to cause the collected liquid refrigerant to smoothly flow into the reservoir 110 of the evaporation panel assembly 100 located below.

In particular, the plurality of absorbers 250 may be arranged in the refrigerant flow space 205 between the one-side heat conduction panel 202A and the other-side heat conduction panel 202B, which are elongated in the left-right direction above the evaporation panel assembly 100, and may be uniformly spaced apart from each another by a predetermined distance in the left-right direction. Thus, 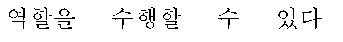 the uniformly condensed liquid refrigerant over the entire refrigerant flow space 205 may be immediately collected by adjacent absorbers 250 without being biased to one side and thereby flow evenly.

Although not illustrated in the drawings, the absorber 250 may include a plurality of pores each having a size that allows a refrigerant in a gas state (gas refrigerant) to pass and flow without interference and allows a refrigerant in a liquid state (liquid refrigerant) to be absorbed by capillary force or surface tension.

In addition, the absorber 250 may be provided in any one form of a metal foam formed by braiding metal wires so that the plurality of pores described above are formed, or a metal sintered body obtained by sintering metal powder.

In particular, the absorber 250 is preferably made of a metal material to efficiently evaporate the absorbed liquid refrigerant by receiving heat transferred from the heating elements via the evaporation panel assembly 100, and more preferably may be made of SUS.

As described above, the plurality of absorbers 250 may be installed to be respectively supported in a plurality of absorber installation grooves 220 provided in the refrigerant flow space 205 of the one-side heat conduction panel 202A and the other-side heat conduction panel 202B.

Meanwhile, the plurality of absorbers 250 and the plurality of absorber installation grooves 220 may each be arranged to be spaced apart in a horizontal direction (more specifically, in a longitudinal direction that is a left-right direction of the evaporation panel assembly 100).

Here, when the absorbers 250 are provided as the metal foam or the metal sintered bodies made of the metal material as described above, they have their own rigidity and hardness, so that the absorbers may also serve to supplementarily reinforce strength of the one-side heat conduction panel 202A and the other-side heat conduction panel 202B, which are manufactured with relatively thin thicknesses as will be described later.

For example, through the plurality of absorber installation grooves 220 formed by the press forming process on the refrigerant flow space 205 side so that the plurality of absorbers 250 may be installed, the rigidity of the one-side heat conduction panel 202A and the other-side heat conduction panel 202B themselves may be increased, and, with respect to an external force acting from the outside toward the refrigerant flow space 205, the plurality of absorbers 250 installed in the refrigerant flow space 205 may themselves be supported outward, thereby maintaining outer shapes of the one-side heat conduction panel 202A and the other-side heat conduction panel 202B.

In contrast, while the plurality of absorbers 250 provide shape-retaining force against external forces acting from the outside toward the refrigerant flow space 205, the plurality of strength reinforcing portions 230, as will be described later, may be mutually joined within the refrigerant flow space 205 to prevent the one-side heat conduction panel 202A and the other-side heat conduction panel 202B from being spaced apart or shaken in response to changes in internal pressure generated during phase change of the refrigerant, thereby providing shape-retaining force against internal pressure.

Here, as illustrated in FIGS. 6 to 8, the one-side heat conduction panel 202A and the other-side heat conduction panel 202B may be formed with the plurality of absorber installation grooves 220 that support the absorbers 250 so as to prevent movement thereof within the refrigerant flow space 205, the absorber installation grooves being uniformly spaced apart at intermediate portions between both ends in a left-right direction, and the plurality of strength reinforcing portions 230 may be formed in regions of the one-side heat conduction panel 202A and the other-side heat conduction panel 202B that are not occupied by the plurality of absorber installation grooves 220.

Meanwhile, as illustrated in FIGS. 6 and 7, the plurality of absorbers 250 may be formed such that lower ends thereof protrude further downward than lower ends of the one-side heat conduction panel 202A and the other-side heat conduction panel 202B so as to be immersed in the reservoir 110 of the evaporation panel assembly 100.

That is, when the lower ends of the one-side heat conduction panel 202A and the other-side heat conduction panel 202B are coupled to the evaporation panel assembly 100 as the condensed liquid refrigerant falls from the refrigerant flow space 205, the plurality of absorbers 250 may have a length that protrudes further downward than the lower ends of the one-side heat conduction panel 202A and the other-side heat conduction panel 202B, such that their lower ends are positioned in the reservoir 110 of the evaporation panel assembly 100.

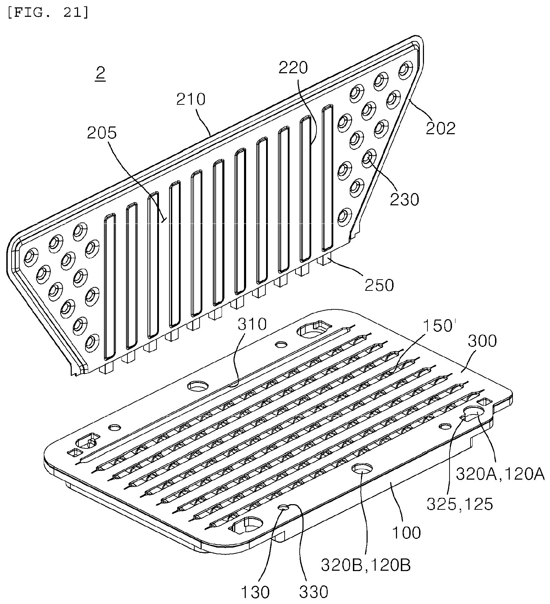

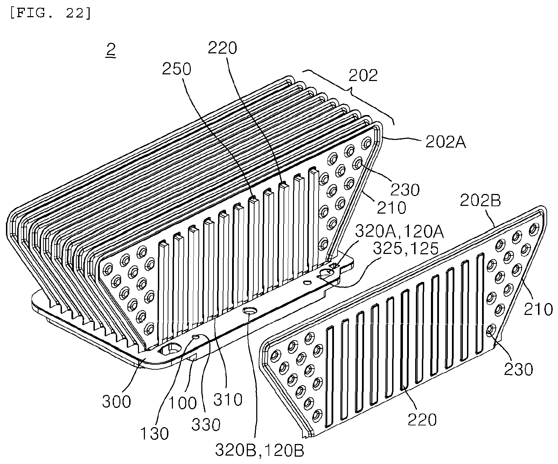

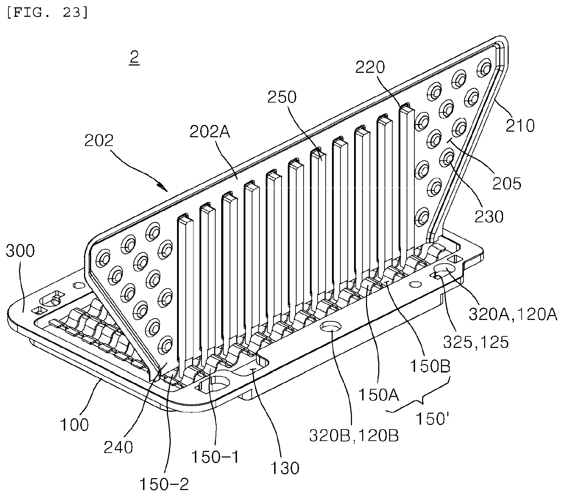

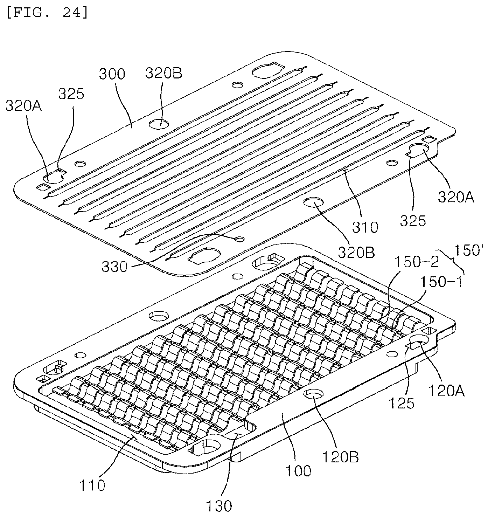

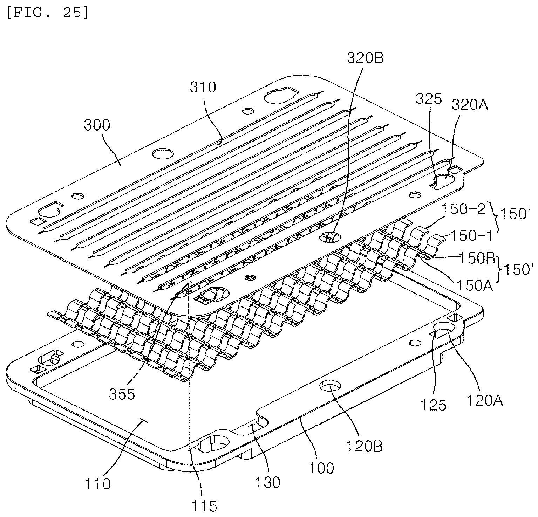

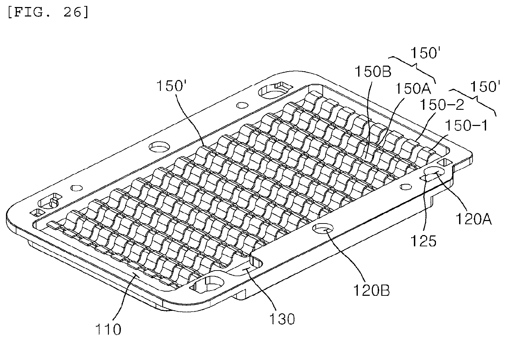

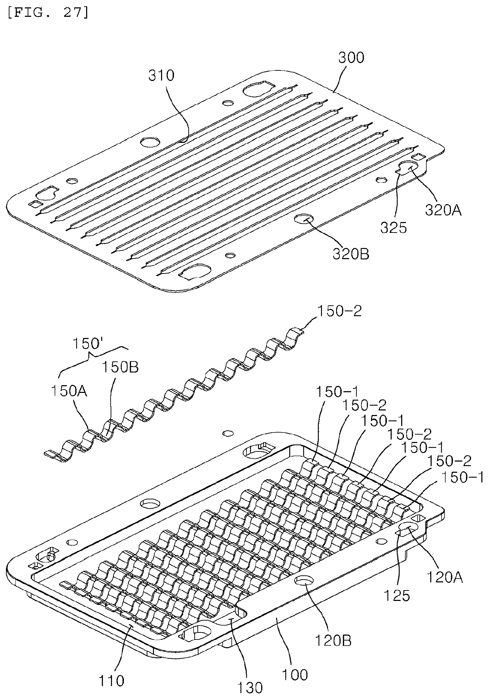

FIG. 20 is an exploded perspective view illustrating a condensing panel assembly according to a second implementation in the configuration of FIG. 2, separated from the evaporation panel assembly, FIG. 21 is an exploded perspective view of FIG. 20, FIG. 22 is an exploded perspective view illustrating the configuration of the condensing panel assembly according to the second implementation of FIG. 20, with the other-side heat conduction panel separated, FIG. 23 is a perspective view illustrating a state in which a single condensing panel assembly according to the second implementation in the configuration of the heat dissipation device of FIG. 20 is coupled to the evaporation panel assembly, with the mounting panel removed, FIG. 24 is an exploded perspective view illustrating the evaporation panel assembly with the mounting panel separated therefrom, FIG. 25 is an exploded perspective view illustrating a configuration in which the mounting panel and a plurality of rigid reinforcing members are separated, FIG. 26 is a perspective view illustrating the configuration of FIG. 24 with the mounting panel removed, and FIG. 27 is an exploded perspective view illustrating one of the plurality of rigid reinforcing members of FIG. 24, separated therefrom.

In the heat dissipation device 2 according to still another embodiment of the present disclosure, respective configurations of the evaporation panel assembly 100 and the mounting panel 300 will be described on the premise that they are identical to those of the heat dissipation device 1 according to the embodiment of the present disclosure described above.

However, in the heat dissipation device 2 according to still another embodiment of the present disclosure, a plurality of rigid reinforcing members 150' may be configured differently as follows compared with the heat dissipation device 1 according to another embodiment of the present disclosure described above.

That is, the plurality of rigid reinforcing members 150' may be arranged to be seated in the reservoir 110 of the evaporation panel assembly 100 and may be disposed to form eight rows in a width direction defined as a front-rear direction.

Here, the plurality of adjacent rigid reinforcing members (see reference numerals 150-1 and 150-2 in FIG. 25) may be arranged to have predetermined spacing distances from each other in the front-rear width direction, and each spacing distance may be arranged to be positioned directly below installation slits 310 of the mounting panel 300 disposed thereabove.

In spaces corresponding to spacing distances between the plurality of rigid reinforcing members 150-1, 150-2 described above, the lower ends 240 of the plurality of condensing panel assemblies 202 according to the second implementation may be inserted, and the plurality of rigid reinforcing members 150' may serve to support the outer side surfaces of the lower ends of the one-side heat conduction panels 202A and the other-side heat conduction panels 202B respectively constituting the condensing panel assemblies 202 according to the second implementation.

More specifically, the plurality of rigid reinforcing members 150' may be arranged in multiple rows in the reservoir 110 of the evaporation panel assembly 100 to support the lower surface of the mounting panel 300 and the bottom surface of the reservoir 110, and the one-side heat conduction panel 202A and the other-side heat conduction panel 202B may be supported, at one lower-side surface and the other lower-side surface thereof, between the plurality of rigid reinforcing members 150'.

In this manner, after the plurality of condensing panel assemblies 202 according to the second implementation are coupled through respective installation slits 310 of the mounting panel 300, welding may be performed along peripheries of the installation slits 310 so as to prevent external leakage of the liquid refrigerant stored in the reservoir 110 of the evaporation panel assembly 100 or the gas refrigerant that phase-changes therefrom and diffuses and flows through the refrigerant flow space 205 of the condensing panel assemblies 202.

Meanwhile, the plurality of rigid reinforcing members 150' may be formed to have a wavy vertical cross-section, and a lower end surface 150B may contact a bottom surface 115 of the reservoir 110 of the evaporation panel assembly 100, while an upper end surface 150A may contact a lower surface 355 corresponding to spaces between the installation slits 310 of the mounting panel 300, and each contacted portion may be joined by a welding method.

In this manner, the plurality of rigid reinforcing members 150' may be joined at respective lower and upper contact ends 150A and 150B to the evaporation panel assembly 100 and the mounting panel 300, thereby serving to reinforce rigidity of respective portions of the evaporation panel assembly 100 and the mounting panel 300, which are provided with relatively thin thicknesses.

Further, the plurality of rigid reinforcing members 150' may be positioned in the reservoir 110 of the evaporation panel assembly 100 and immersed in the stored liquid refrigerant, thereby not only indirectly serving to transfer heat supplied from the heating elements to the liquid refrigerant but also serving to assist more active gas-liquid conversion (phase change) by increasing a heat transfer area at this time.

To this end, the plurality of rigid reinforcing members 150' may be made of a metal material having excellent thermal conductivity, and may preferably be made of SUS, which is the same material as the condensing panel assembly 202 according to the second implementation, or Cu, which is the same material as the evaporation panel assembly 100.

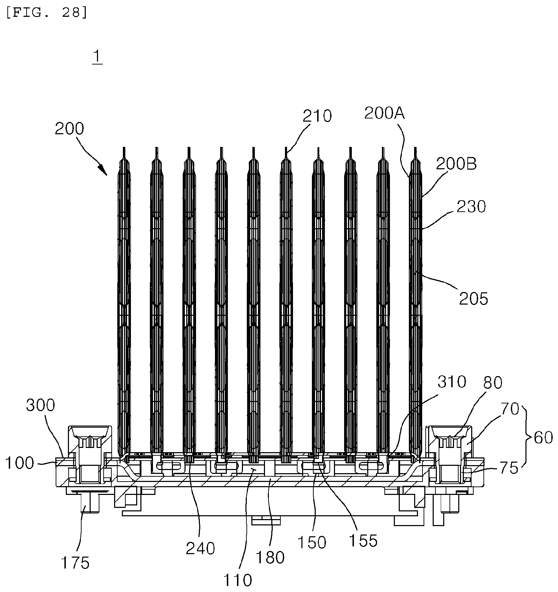

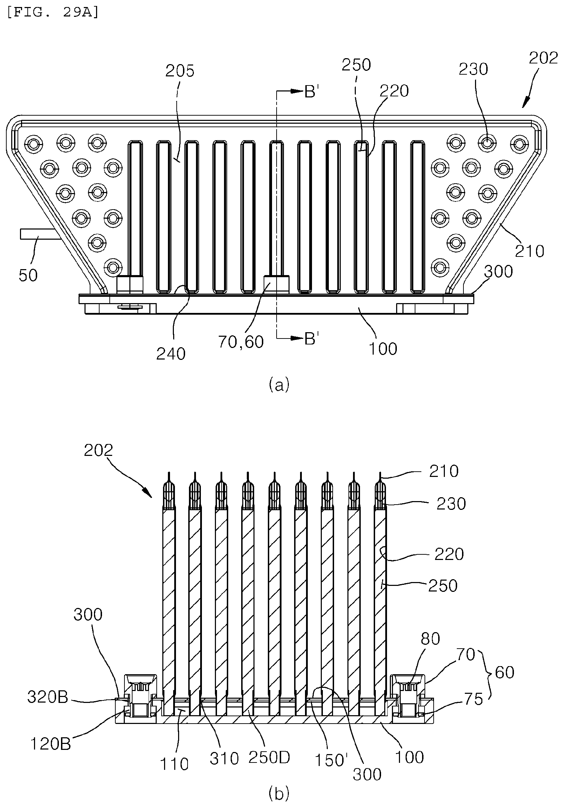

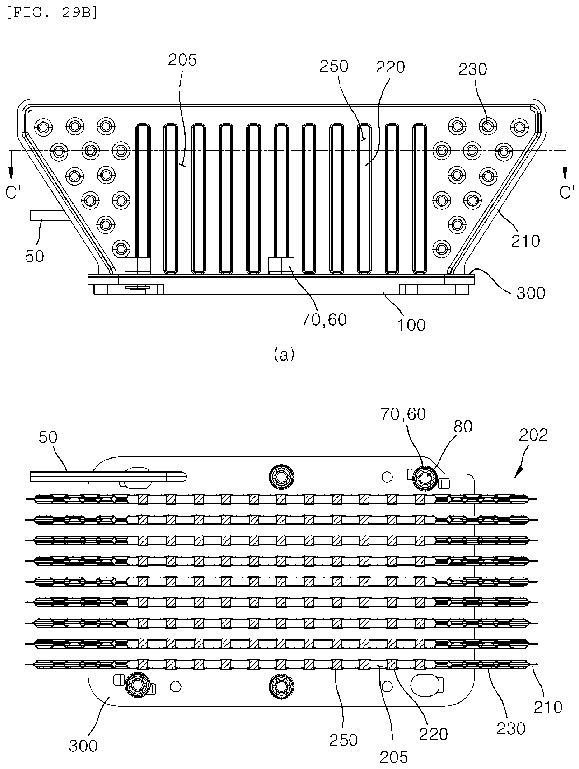

FIG. 28 is a cross-sectional view taken along line A'-A' of FIG. 1, FIG. 29A is a front view (a) of FIG. 2 and a cross-sectional view (b) taken along line B'-B', and FIG. 29B is a front view (a) of FIG. 2 and a cross-sectional view (b) taken along line C'-C'.

A heat dissipation process by the heat dissipation device 1 according to another embodiment of the present disclosure will be briefly described as follows. As illustrated in FIG. 28, when a refrigerant in a liquid state (liquid refrigerant) stored in the reservoir 110 of the evaporation panel assembly 100 receives heat from the heating elements via the lower surface of the evaporation panel assembly 100 or via the heat transfer panel 180 of the heat transfer plate assembly 170 as a medium and then undergoes a phase change into a refrigerant in a gas state (gas refrigerant), the gas refrigerant diffuses and flows toward the refrigerant flow space 205 of the plurality of condensing panel assemblies 200 implemented according to the first implementation. The liquid refrigerant condensed through heat exchange with outside air (outdoor air) easily falls in a gravity direction through a first refrigerant flow path 205a of the refrigerant flow space 205, and the liquid refrigerant is collected again in the reservoir 110 of the evaporation panel assembly 100. This process is repeated, thereby achieving gas-liquid circulation.

At this time, in the evaporation panel assembly 100, the mounting panel 300 is firmly supported by the plurality of rigid reinforcing members 150, and the condensing panel assembly 200 may have inherent rigidity capable of readily responding to changes in internal pressure during gas-liquid circulation by the plurality of strength reinforcing portions 230.

Meanwhile, as illustrated in FIGS. 29A and 29B, the heat dissipation device 2 according to still another embodiment of the present disclosure may also achieve a gas-liquid circulation cycle, like the heat dissipation device 1 according to the embodiment of the present disclosure described above, in which a phase change from liquid refrigerant to gas refrigerant occurs in the reservoir 110 of the evaporation panel assembly 100 and a phase change from gas refrigerant to liquid refrigerant is repeated through the refrigerant flow space 205 of the plurality of condensing panel assemblies 200 according to the second implementation.

At this time, the liquid refrigerant condensed inside the plurality of condensing panel assemblies 200 may be provided so as to be readily and uniformly collected, via the absorbers 250, into the reservoir 110 of the evaporation panel assembly 100 located below in a gravity direction, thereby enabling more rapid gas-liquid circulation.

In each of the condensing panel assemblies 200 and 202 of the heat dissipation devices 1 and 2 according to embodiments of the present disclosure configured as described above, even when the metal material of the base metal panel members forming the one-side heat conduction panels 200A and 202A and the other-side heat conduction panels 200B and 202B adopts SUS, whose thermal conductivity corresponds to one-tenth or less of that of aluminum Al, which is most commonly used, the panels are manufactured with a reduced thickness so that substantially all of the heat generated from the heating elements is used only for gas-liquid (phase) change of the refrigerant that substantially performs a heat dissipation function. In addition, by having a technical feature designed to minimize conversion of thermal energy into physical force through changes in internal pressure within the refrigerant flow space 205 resulting from the reduced thickness, an advantage of maximizing heat dissipation performance is provided.

As described above, a condensing panel assembly and a heat dissipation device including the same according to embodiments of the present disclosure has been described in detail with reference to the accompanying drawings. However, embodiments of the present disclosure are not necessarily limited to the above-described embodiments, and it will be apparent that various modifications and equivalent implementations are possible by those skilled in the art. Therefore, the true scope of the present disclosure is defined by the claims set forth below.

### [Industrial Applicability]

The present disclosure provides a condensing panel assembly and a heat dissipation device including the same, which prevent physical shaking caused by an increase in internal pressure during gas-liquid circulation of a refrigerant and achieve a shorter gas-liquid circulation cycle.

## Claims

1. A condensing panel assembly comprising:
a one-side heat conduction panel that is a metal panel member having at least a predetermined thermal conductivity; and
an other-side heat conduction panel that is a metal panel member identical to the one-side heat conduction panel,
wherein peripheral edges of the one-side heat conduction panel and the other-side heat conduction panel, except for lower ends thereof in a gravity direction, are joined to each other to form a refrigerant flow space through which a refrigerant flows, and
wherein the lower ends of the one-side heat conduction panel and the other-side heat conduction panel are coupled to communicate with an evaporation panel assembly in which a reservoir is formed to store condensed liquid refrigerant from the refrigerant flow space after falling.

2. The condensing panel assembly of claim 1, wherein the one-side heat conduction panel and the other-side heat conduction panel are formed with a plurality of strength reinforcing portions recessed inward to contact each other within the refrigerant flow space.

3. The condensing panel assembly of claim 2, wherein portions of the plurality of strength reinforcing portions that contact each other within the refrigerant flow space are joined by a welding method.

4. The condensing panel assembly of claim 2, wherein the refrigerant flow space comprises:
a first refrigerant flow path formed to have a maximum spacing in a thickness direction of the refrigerant flow space, corresponding to a maximum separation distance between the one-side heat conduction panel and the other-side heat conduction panel, and formed to surround a periphery of each of the plurality of strength reinforcing portions; and
a second refrigerant flow path formed by being recessed from the one-side heat conduction panel and the other-side heat conduction panel toward the refrigerant flow space, and formed between each of the plurality of strength reinforcing portions and the first refrigerant flow path.

5. The condensing panel assembly of claim 4, wherein a recessed depth of the second refrigerant flow path toward the refrigerant flow space is formed such that the second refrigerant flow path is spaced apart from the refrigerant flow space in the thickness direction within the refrigerant flow space.

6. The condensing panel assembly of claim 4, wherein a recessed depth of the second refrigerant flow path is greater than at least a recessed depth of the first refrigerant flow path and smaller than the plurality of strength reinforcing portions.

7. The condensing panel assembly of claim 4, wherein the second refrigerant flow path is defined to be distinguished from an adjacent second refrigerant flow path by the first refrigerant flow path.

8. The condensing panel assembly of claim 1, wherein the lower ends of the one-side heat conduction panel and the other-side heat conduction panel are coupled to overlap with the reservoir of the evaporation panel assembly.

9. The condensing panel assembly of claim 8, wherein the lower ends of the one-side heat conduction panel and the other-side heat conduction panel pass through installation slits formed in a mounting panel coupled to an upper surface of the evaporation panel assembly so as to mediate coupling with the evaporation panel assembly, and are coupled so as to be seated in the reservoir.

10. The condensing panel assembly of claim 9, wherein the one-side heat conduction panel and the other-side heat conduction panel are welded along peripheries of the installation slits after being coupled to the installation slits of the mounting panel.

11. The condensing panel assembly of claim 9,
wherein a plurality of rigid reinforcing members coupled to support a lower surface of the mounting panel and a bottom surface of the reservoir are arranged in the reservoir of the evaporation panel assembly in a plurality of spaced rows, and
wherein upper surfaces of the one-side heat conduction panel and the other-side heat conduction panel, which are defined by division grooves formed in a groove shape on upper portions of the plurality of rigid reinforcing members, are supported by the lower surface of the mounting panel.

12. The condensing panel assembly of claim 1, wherein the peripheral edges of the one-side heat conduction panel and the other-side heat conduction panel, except for the lower ends coupled to the evaporation panel assembly, are joined to each other to form the refrigerant flow space.

13. The condensing panel assembly of claim 1, further comprising:
a plurality of condensed refrigerant collection absorbers disposed in the refrigerant flow space formed between the one-side heat conduction panel and the other-side heat conduction panel to guide condensed refrigerant.

14. A condensing panel assembly comprising:
a one-side heat conduction panel that is a metal panel member having at least a predetermined thermal conductivity;
an other-side heat conduction panel that is a metal panel member identical to the one-side heat conduction panel;
and
a plurality of condensed refrigerant collection absorbers (hereinafter abbreviated as "absorbers") disposed in a refrigerant flow space formed between the one-side heat conduction panel and the other-side heat conduction panel, the absorbers being elongated in a gravity direction and arranged to be supported while simultaneously contacting an inner surface of the one-side heat conduction panel forming one heat dissipation surface of the refrigerant flow space and an inner surface of the other-side heat conduction panel forming another heat dissipation surface of the refrigerant flow space.

15. The condensing panel assembly of claim 14, wherein the absorber is provided in any one form of a metal foam formed by braiding metal wires or a metal sintered body obtained by sintering metal powder.

16. The condensing panel assembly of claim 14, wherein the absorber is formed with a plurality of pores having sizes that allow liquid refrigerant condensed in the refrigerant flow space to be absorbed by capillary force or surface tension.

17. The condensing panel assembly of claim 14, wherein the one-side heat conduction panel and the other-side heat conduction panel are formed with a plurality of absorber installation grooves corresponding to the number of the absorbers, the absorber installation grooves supporting the absorbers to prevent movement thereof within the refrigerant flow space.

18. The condensing panel assembly of claim 17, wherein the plurality of absorbers and the plurality of absorber installation grooves are each arranged to be spaced apart in a horizontal direction.

19. The condensing panel assembly of claim 14, wherein, when lower ends of the one-side heat conduction panel and the other-side heat conduction panel are coupled to an evaporation panel assembly in which a reservoir is formed to store liquid refrigerant that has fallen after being condensed from the refrigerant flow space, the absorber has a length that protrudes further downward than the lower ends of the one-side heat conduction panel and the other-side heat conduction panel such that a lower end thereof is positioned in the reservoir of the evaporation panel assembly.

20. The condensing panel assembly of claim 19, wherein peripheral edges of the one-side heat conduction panel and the other-side heat conduction panel, except for the lower ends coupled to the evaporation panel assembly, are joined to each other to form the refrigerant flow space.

21. The condensing panel assembly of claim 20, wherein the one-side heat conduction panel and the other-side heat conduction panel are formed with a plurality of strength reinforcing portions recessed inward so as to contact each other within the refrigerant flow space.

22. The condensing panel assembly of claim 21, wherein portions of the plurality of strength reinforcing portions that contact each other within the refrigerant flow space are joined by a welding method.

23. The condensing panel assembly of claim 21,
wherein the one-side heat conduction panel and the other-side heat conduction panel are formed with a plurality of absorber installation grooves corresponding to the number of the absorbers, the absorber installation grooves supporting the absorbers so as to prevent movement thereof within the refrigerant flow space, and
wherein the plurality of strength reinforcing portions are formed in regions of the one-side heat conduction panel and the other-side heat conduction panel that are not occupied by the plurality of absorber installation grooves.

24. The condensing panel assembly of claim 19, wherein the lower ends of the one-side heat conduction panel and the other-side heat conduction panel pass through installation slits formed in a mounting panel coupled to an upper surface of the evaporation panel assembly so as to mediate coupling with the evaporation panel assembly, and are coupled so as to be seated in the reservoir.

25. The condensing panel assembly of claim 24, wherein the one-side heat conduction panel and the other-side heat conduction panel are welded along peripheries of the installation slits after being coupled to the installation slits of the mounting panel.

26. The condensing panel assembly of claim 24,
wherein a plurality of rigid reinforcing members coupled to support a lower surface of the mounting panel and a bottom surface of the reservoir are arranged in the reservoir of the evaporation panel assembly in a plurality of rows, and
wherein the one-side heat conduction panel and the other-side heat conduction panel are supported, at one lower-side surface and the other lower-side surface thereof, between the plurality of rigid reinforcing members.

27. A heat dissipation device, comprising:
an evaporation panel assembly that is in surface thermal contact with a heat-generating surface of a heating element and in which a reservoir storing a liquid refrigerant of a refrigerant is formed;
a plurality of condensing panel assemblies that are coupled to the evaporation panel assembly and in which a gas refrigerant phase-changed in the reservoir diffuses and condenses; and
a mounting panel configured to mediate slit coupling between the evaporation panel assembly and the condensing panel assemblies,
wherein the evaporation panel assembly is made of copper, and the condensing panel assemblies are made of SUS.

28. The heat dissipation device of claim 27, wherein the plurality of condensing panel assemblies form a refrigerant flow space through which the liquid refrigerant and the gas refrigerant flow, by joining peripheral edges of two base panels made of SUS and a plurality of strength reinforcing portions formed therein.

29. The heat dissipation device of claim 27,
wherein the plurality of condensing panel assemblies are formed with a plurality of refrigerant flow paths through which the liquid refrigerant flows in a gravity direction, and
wherein each of the plurality of refrigerant flow paths is provided with an absorber formed of a braided wire mesh.

30. The heat dissipation device of claim 27, wherein a plurality of strength reinforcing members for reinforcing strength between the evaporation panel assembly and the mounting panel are coupled to the evaporation panel assembly by a brazing method.

31. A heat dissipation device, comprising:
an evaporation panel assembly in which a reservoir storing a refrigerant capable of phase change according to temperature is formed and at least a portion of a lower surface thereof is in surface thermal contact with heat-generating surfaces of heating elements; and
a plurality of condensing panel assemblies coupled to the evaporation panel assembly to communicate with the reservoir and configured to release heat transferred from the heating elements through heat exchange with outside air (outdoor air),
wherein each of the plurality of condensing panel assemblies comprises:
a one-side heat conduction panel that is a metal panel member having at least a predetermined thermal conductivity; and
an other-side heat conduction panel that is a metal panel member identical to the one-side heat conduction panel,
wherein peripheral edges of the one-side heat conduction panel and the other-side heat conduction panel, except for lower ends thereof in a gravity direction, are joined to each other to form a refrigerant flow space through which a refrigerant flows, and
wherein the lower ends of the one-side heat conduction panel and the other-side heat conduction panel are coupled to communicate with the reservoir of the evaporation panel assembly.

32. The heat dissipation device of claim 31, wherein the peripheral edges of the one-side heat conduction panel and the other-side heat conduction panel, except for the lower ends coupled to the evaporation panel assembly, are joined to each other to form the refrigerant flow space.

33. The heat dissipation device of claim 31, wherein the one-side heat conduction panel and the other-side heat conduction panel are formed with a plurality of strength reinforcing portions recessed inward so as to contact each other within the refrigerant flow space.

34. The heat dissipation device of claim 33, wherein portions of the plurality of strength reinforcing portions that contact each other within the refrigerant flow space are joined by a welding method.

35. The heat dissipation device of claim 33, wherein the refrigerant flow space comprises:
a first refrigerant flow path formed to have a maximum spacing in a thickness direction of the refrigerant flow space, corresponding to a maximum separation distance between the one-side heat conduction panel and the other-side heat conduction panel, and formed to surround a periphery of each of the plurality of strength reinforcing portions; and
a second refrigerant flow path formed by being recessed from the one-side heat conduction panel and the other-side heat conduction panel toward the refrigerant flow space, and formed between each of the plurality of strength reinforcing portions and the first refrigerant flow path.

36. The heat dissipation device of claim 35, wherein a recessed depth of the second refrigerant flow path toward the refrigerant flow space is formed so that the second refrigerant flow path is spaced apart from the refrigerant flow space in a thickness direction within the refrigerant flow space.

37. The heat dissipation device of claim 35, wherein a recessed depth of the second refrigerant flow path is greater than at least a recessed depth of the first refrigerant flow path and smaller than the plurality of strength reinforcing portions.

38. The heat dissipation device of claim 35, wherein the second refrigerant flow path is defined so as to be distinguished from an adjacent second refrigerant flow path by the first refrigerant flow path.

39. The heat dissipation device of claim 31, wherein lower ends of the one-side heat conduction panel and the other-side heat conduction panel are coupled to overlap with the reservoir of the evaporation panel assembly.

40. The heat dissipation device of claim 39, further comprising:
a mounting panel coupled to an upper surface of the evaporation panel assembly so as to mediate coupling between the evaporation panel assembly and the plurality of condensing panel assemblies,
wherein the lower ends of the one-side heat conduction panel and the other-side heat conduction panel pass through installation slits formed in the mounting panel and are coupled so as to be seated in the reservoir.

41. The heat dissipation device of claim 40, wherein the one-side heat conduction panel and the other-side heat conduction panel are welded along peripheries of the installation slits after being coupled to the installation slits of the mounting panel.

42. The heat dissipation device of claim 40,
wherein a plurality of rigid reinforcing members coupled to support a lower surface of the mounting panel and a bottom surface of the reservoir are arranged in the reservoir of the evaporation panel assembly in a plurality of spaced rows, and
wherein upper surfaces of the one-side heat conduction panel and the other-side heat conduction panel, which are defined by division grooves formed in a groove shape on upper portions of the plurality of rigid reinforcing members, are supported by the lower surface of the mounting panel.

43. The heat dissipation device of claim 31, wherein the condensing panel assembly further comprises:
a plurality of condensed refrigerant collection absorbers (hereinafter abbreviated as "absorbers") disposed in a refrigerant flow space formed between the one-side heat conduction panel and the other-side heat conduction panel, the absorbers being elongated in a gravity direction and arranged so as to be supported while simultaneously contacting an inner surface of the one-side heat conduction panel forming one heat dissipation surface of the refrigerant flow space and an inner surface of the other-side heat conduction panel forming another heat dissipation surface of the refrigerant flow space.

44. The heat dissipation device of claim 43, wherein the absorber is provided in any one form of a metal foam formed by braiding metal wires or a metal sintered body obtained by sintering metal powder.

45. The heat dissipation device of claim 43, wherein the absorber is formed with a plurality of pores having sizes that allow liquid refrigerant condensed in the refrigerant flow space to be absorbed by capillary force or surface tension.

46. The heat dissipation device of claim 44, wherein the one-side heat conduction panel and the other-side heat conduction panel are formed with a plurality of absorber installation grooves corresponding to the number of the absorbers, the absorber installation grooves supporting the absorbers so as to prevent movement thereof within the refrigerant flow space.

47. The heat dissipation device of claim 46, wherein the plurality of absorbers and the plurality of absorber installation grooves are each arranged to be spaced apart in a horizontal direction.

48. The heat dissipation device of claim 44, wherein, when the lower ends of the one-side heat conduction panel and the other-side heat conduction panel are coupled to the evaporation panel assembly in which the reservoir is formed to store liquid refrigerant that has fallen after being condensed from the refrigerant flow space, the absorber has a length that protrudes further downward than the lower ends of the one-side heat conduction panel and the other-side heat conduction panel such that a lower end thereof is positioned in the reservoir of the evaporation panel assembly.

49. The heat dissipation device of claim 31, further comprising:
a heat transfer plate assembly configured to receive heat generated from the heating elements and to mediate transfer thereof to a lower surface of the evaporation panel assembly.

50. The heat dissipation device of claim 49, wherein the heat transfer plate assembly comprises:
a coupling frame provided in a quadrangular frame shape having an empty center; and
a heat transfer panel coupled to a central portion of the coupling frame, a lower surface of the heat transfer panel being in surface thermal contact with heat-generating surfaces of the heating elements and an upper surface thereof being in surface thermal contact with a lower surface of the evaporation panel assembly.

51. The heat dissipation device of claim 50, wherein at least one pair of panel fixing hooks for fixing the heat transfer panel are integrally formed at an inner end of the coupling frame.

52. The heat dissipation device of claim 50, further comprising:
a mounting panel coupled to an upper surface of the evaporation panel assembly so as to mediate coupling between the evaporation panel assembly and the plurality of condensing panel assemblies,
wherein the coupling frame is formed with support hook portions that are inserted through extension holes formed in the evaporation panel assembly and the mounting panel and are caught and fastened on an upper surface of the mounting panel.
